# EUROPEAN PATENT APPLICATION

(11) **EP 4 766 108 A1**
(43) Date of publication of application: **24.06.2026**
(21) Application number: 25223929.8
(22) Date of filing: 16.12.2025
(51) Int. Cl.: H10H 29/80, H10H 29/855

(54) **DISPLAY DEVICE, METHOD OF MANUFACTURING THE SAME, AND ELECTRONIC DEVICE INCLUDING THE SAME**

(30) Priority: 17.12.2024 KR 20240189076
(71) Applicant: Samsung Electronics Co., Ltd., Suwon-si, Gyeonggi-do 16677 (KR)
(72) Inventor: HWANG, Kyungwook, 16677 Suwon-si (KR); LEE, Sangyun, 16678 Suwon-si (KR); ROH, Sookyoung, 16678 Suwon-si (KR); AHN, Sungmo, 16678 Suwon-si (KR); OH, Youngtek, 16677 Suwon-si (KR); HWANG, Junsik, 16678 Suwon-si (KR)
(74) Representative: Arnold & Siedsma

(57) **Abstract**

A display device includes a backplane substrate including at least one drive device, at least one pixel including a first epitaxial structure, a second epitaxial structure, and a third epitaxial structure sequentially stacked on the backplane substrate, a lens on the third epitaxial structure, and an anti-reflection layer between the third epitaxial structure and the lens, where each of the first epitaxial structure, the second epitaxial structure, and the third epitaxial structure includes a first conductivity-type semiconductor layer, an active layer, and a second conductivity-type semiconductor layer, the first epitaxial structure is configured to emit first wavelength light, the second epitaxial structure is configured to emit second wavelength light, and the third epitaxial structure is configured to emit third wavelength light, and the anti-reflection layer includes a material having a refractive index in a range of 1.7 to 2.1.

## Description

### BACKGROUND

### 1. Field

The disclosure relates to a display device capable of displaying a color image, a method of manufacturing the same, and an electronic device including the display device.

### 2. Description of Related Art

Liquid crystal displays (LCD) and organic light emitting diode (OLED) displays are widely used as display devices. In addition, a technology for manufacturing high-resolution display devices using micro light emitting diodes (micro-LEDs) is being developed. Light emitting diodes (LEDs) have the advantages of having low-power consumption and being eco-friendly. These advantages increase the industrial demand for LEDs.

LED displays that directly use micro LEDs as pixels have been developed and commercialized. LED display pixels may be designed in various ways, and recently, various technologies have been introduced to vertically stack micro LEDs (R-LEDs) that emit red light (R), micro LEDs (G-LEDs) that emit green light (G-LEDs), and micro LEDs (B-LEDs) that emit blue light (B). However, satisfactory results in terms of light efficiency and bonding have not been obtained for structures in which micro LEDs are vertically stacked.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

Provided is a display device having a vertical stack structure of an epitaxial type.

Provided is a method of manufacturing a display device having a vertical stack structure of an epitaxial type.

Provided is an electronic device including a display device having a vertical stack structure of an epitaxial type.

Additional aspects will be set forth in part in the description which follows and, in part, will be apparent from the description, or may be learned by practice of the presented embodiments of the disclosure.

According to an aspect of the disclosure, a display device may include a backplane substrate including at least one drive device, at least one pixel including a first epitaxial structure, a second epitaxial structure, and a third epitaxial structure sequentially stacked on the backplane substrate, a lens on the third epitaxial structure, and an anti-reflection layer between the third epitaxial structure and the lens, where each of the first epitaxial structure, the second epitaxial structure, and the third epitaxial structure includes a first conductivity-type semiconductor layer, an active layer, and a second conductivity-type semiconductor layer, the first epitaxial structure is configured to emit first wavelength light, the second epitaxial structure is configured to emit second wavelength light, and the third epitaxial structure is configured to emit third wavelength light, the anti-reflection layer includes a material having a refractive index in a range of 1.7 to 2.1, and the anti-reflection layer has a thickness in a range of 75 nm to 110 nm.

The first wavelength light may include red wavelength light, the second wavelength light may include green wavelength light, and the third wavelength light may include blue wavelength light.

The display device may include a reflective layer between the backplane substrate and the first epitaxial structure.

The display device may include a first p-type electrode, a second p-type electrode, and a third p-type electrode between the backplane substrate and the first epitaxial structure and laterally spaced apart from each other, and an n-type electrode between the third epitaxial structure and the anti-reflection layer.

The at least one pixel may include a plurality of pixels, and the anti-reflection layer may be shared as a single body with the plurality of pixels.

The at least one pixel may include a plurality of pixels, and the anti-reflection layer may include a plurality of anti-reflection layer portions, the plurality of anti-reflection layer portions respectively corresponding to the plurality of pixels.

A refractive index of the second conductivity-type semiconductor layer in the third epitaxial structure may be n1, a refractive index of the anti-reflection layer may be n2, and a refractive index of the lens may be n3 and n1>n2>n3.

According to an aspect of the disclosure, a display device may include a backplane substrate including at least one drive device, a first epitaxial structure, a second epitaxial structure, and a third epitaxial structure sequentially stacked on the backplane substrate, a lens on the third epitaxial structure, a first anti-reflection layer on the third epitaxial structure, and a second anti-reflection layer between the first anti-reflection layer and the lens, where each of the first epitaxial structure, the second epitaxial structure, and the third epitaxial structure includes a first conductivity-type semiconductor layer, an active layer, and a second conductivity-type semiconductor layer, the first epitaxial structure is configured to emit first wavelength light, the second epitaxial structure is configured to emit second wavelength light, and the third epitaxial structure is configured to emit third wavelength light, the first anti-reflection layer has a first refractive index, and the second anti-reflection layer has a second refractive index that is less than the first refractive index, and the first anti-reflection layer and the second anti-reflection layer each have a thickness that is greater than 0 and less than or equal to 200 nm.

The first wavelength light may include red wavelength light, the second wavelength light may include green wavelength light, and the third wavelength light may include blue wavelength light.

The display device may include a reflective layer between the backplane substrate and the first epitaxial structure.

The first refractive index may be 1.9 or more, and the second refractive index may be 1.9 or less.

A refractive index of the second conductivity-type semiconductor layer in the third epitaxial structure may be n1, the first refractive index may be n21, the second refractive index may be n22, and a refractive index of the lens may be n3, and n1>n21>n22>n3.

According to an aspect of the disclosure, a method of manufacturing a display device may include forming a third epitaxial structure on a substrate, forming a second epitaxial structure on the third epitaxial structure, preparing a vertical stack structure by forming a first epitaxial structure on an upper portion of the second epitaxial structure, forming a backplane substrate, combining the vertical stack structure with the backplane substrate such that the first epitaxial structure faces the backplane substrate, removing the substrate, forming an anti-reflection layer on the third epitaxial structure, and forming a lens on the anti-reflection layer, where each of the first epitaxial structure, the second epitaxial structure, and the third epitaxial structure includes a first conductivity-type semiconductor layer, an active layer, and a second conductivity-type semiconductor layer, the anti-reflection layer includes a material having a refractive index in a range of 1.7 to 2.1, and the anti-reflection layer has a thickness in a range of 75 nm to 110 nm.

The first epitaxial structure may be configured to emit red wavelength light, the second epitaxial structure may be configured to emit green wavelength light, and the third epitaxial structure may be configured to emit blue wavelength light.

The method may include forming a first p-type electrode, a second p-type electrode, and a third p-type electrode laterally spaced apart from each other between the backplane substrate and the first epitaxial structure, and forming an n-type electrode between the third epitaxial structure and the anti-reflection layer.

A refractive index of the second conductivity-type semiconductor layer in the third epitaxial structure may be n1, a refractive index of the anti-reflection layer may be n2, and a refractive index of the lens may be n3, and n1>n2>n3.

According to an aspect of the disclosure, an electronic device may include a display device configured to form an image, and a waveguide configured to guide the image to a user's eyes, where the display device may include a backplane substrate including at least one drive device, a first epitaxial structure, a second epitaxial structure, and a third epitaxial structure sequentially stacked on the backplane substrate, a lens on the third epitaxial structure, and an anti-reflection layer between the third epitaxial structure and the lens, where each of the first epitaxial structure, the second epitaxial structure, and the third epitaxial structure includes a first conductivity-type semiconductor layer, an active layer, and a second conductivity-type semiconductor layer, the first epitaxial structure is configured to emit first wavelength light, the second epitaxial structure is configured to emit second wavelength light, and the third epitaxial structure is configured to emit third wavelength light, the anti-reflection layer includes a material having a refractive index in a range of 1.7 to 2.1, and the anti-reflection layer has a thickness in a range of 75 nm to 110 nm.

The first wavelength light may include red wavelength light, the second wavelength light may include green wavelength light, and the third wavelength light may include blue wavelength light.

The electronic device may include a first p-type electrode, a second p-type electrode, and a third p-type electrode between the backplane substrate and the first epitaxial structure, and laterally spaced apart from each other, and an n-type electrode between the third epitaxial structure and the anti-reflection layer.

A refractive index of the second conductivity-type semiconductor layer in the third epitaxial structure may be n1, a refractive index of the anti-reflection layer may be n2, and a refractive index of the lens may be n3, and n1>n2>n3.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1A is a diagram illustrating a display device according to one or more embodiments;
FIG. 1B is a diagram illustrating an example of further including a reflective layer in the display device illustrated in FIG. 1A according to one or more embodiments;
FIG. 2 is a diagram illustrating an example of adding an electrode structure to a display device according to one or more embodiments;
FIG. 3 is a diagram illustrating an example in which an anti-reflection layer is commonly provided for a plurality of pixels in a display device according to one or more embodiments;
FIG. 4 is a diagram illustrating an example in which an anti-reflection layer is separately provided for each of a plurality of pixels in a display device according to one or more embodiments;
FIG. 5 is a diagram illustrating an anti-reflection layer, a first layer provided on one surface of the anti-reflection layer, and a second layer provided on the other surface of the anti-reflection layer according to one or more embodiments;
FIG. 6 is a graph illustrating a result of simulating transmittance of blue light (Blue) incident on the anti-reflection layer at an incident angle of 0 to 90 degrees according to one or more embodiments;
FIG. 7 is a graph illustrating a result of simulating transmittance of green light (Green) incident on the anti-reflection layer at an incident angle of 0 to 90 degrees according to one or more embodiments;
FIG. 8 is a graph illustrating a result of simulating transmittance of red light (Red) incident on the anti-reflection layer at an incident angle of 0 to 90 degrees according to one or more embodiments;
FIG. 9 is a graph illustrating simulation of transmittance according to thickness for an anti-reflection layer including an Al₂O₃ monolayer according to one or more embodiments;
FIG. 10 is a graph illustrating simulation of transmittance according to thickness for an anti-reflection layer including a monolayer having a refractive index n (n=1.9) according to one or more embodiments;
FIG. 11 is a graph illustrating simulation of transmittance according to thickness for an anti-reflection layer including a SiN monolayer according to one or more embodiments;
FIG. 12 is a graph illustrating simulation of transmittance according to thickness for a SiO₂ monolayer as a comparative example;
FIG. 13 is a graph illustrating simulation of transmittance according to thickness for a TiO₂ monolayer as another comparative example;
FIG. 14 is a diagram illustrating an example in which a display device according to one or more embodiments includes two anti-reflection layers.
FIG. 15 is a diagram illustrating a simulation result of transmittance of blue light while changing refractive indices and thicknesses of first and second anti-reflection layers according to one or more embodiments;
FIG. 16 is a diagram illustrating a simulation result of transmittance of blue light while changing a thickness of a first anti-reflection layer including SiN and a thickness of a second anti-reflection layer including Al₂O₃ in a range of 0 nm to 200 nm according to one or more embodiments;
FIG. 17 is a diagram illustrating a simulation result for transmittance of green light while changing a thickness of a first anti-reflection layer including SiN and a thickness of a second anti-reflection layer including Al₂O₃ in a range of 0 nm to 200 nm according to one or more embodiments;
FIG. 18 is a diagram illustrating a simulation result for transmittance of red light while changing a thickness of a first anti-reflection layer including SiN and a thickness of a second anti-reflection layer including Al₂O₃ in a range of 0 nm to 200 nm according to one or more embodiments;
FIG. 19 is a diagram illustrating a simulation result for transmittance of blue light while changing a thickness of a first anti-reflection layer including TiO₂ and a thickness of a second anti-reflection layer including a material of a refractive index n (n=1.9) in a range of 0 nm to 200 nm according to one or more embodiments;
FIG. 20 is a diagram illustrating a simulation result for transmittance of green light while changing a thickness of a first anti-reflection layer including TiO₂ and a thickness of a second anti-reflection layer including a material of a refractive index n (n=1.9) in a range of 0 nm to 200 nm according to one or more embodiments;
FIG. 21 is a diagram illustrating a simulation result for transmittance of red light while changing a thickness of a first anti-reflection layer including TiO₂ and a thickness of a second anti-reflection layer including a material of a refractive index n (n=1.9) in a range of 0 nm to 200 nm according to one or more embodiments;
FIG. 22 is a diagram illustrating a simulation result for transmittance of blue light while changing a thickness of a first anti-reflection layer including SiO₂ and a thickness of a second anti-reflection layer including Al₂O₃ in a range of 0 nm to 200 nm according to one or more embodiments;
FIG. 23 is a diagram illustrating a simulation result for transmittance of green light while changing a thickness of a first anti-reflection layer including SiO₂ and a thickness of a second anti-reflection layer including Al₂O₃ in a range of 0 nm to 200 nm according to one or more embodiments;
FIG. 24 is a diagram illustrating a simulation result for transmittance of red light while changing a thickness of a first anti-reflection layer including SiO₂ and a thickness of a second anti-reflection layer including Al₂O₃ in a range of 0 nm to 200 nm according to one or more embodiments;
FIG. 25 is a flowchart illustrating a method of manufacturing a display device according to one or more embodiments;
FIG. 26 is a diagram of an electronic device according to one or more embodiments;
FIG. 27 is a diagram illustrating an example in which a micro light emitting display device according to one or more embodiments is applied to a mobile device;
FIG. 28 is a diagram illustrating an example in which a micro light emitting display device according to one or more embodiments is applied to a vehicle display device;
FIG. 29 is a diagram illustrating an example in which a micro light emitting display device according to one or more embodiments is applied to augmented reality glasses;
FIG. 30 is a diagram illustrating an example in which a micro light emitting display device according to one or more embodiments is applied to a signage; and
FIG. 31 is a diagram illustrating an example in which a micro light emitting display device according to one or more embodiments is applied to a wearable display.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, a display device, a manufacturing method thereof, and an electronic device including the display device according to various embodiments will be described in detail with reference to the accompanying drawings. In the following drawings, the same reference numerals refer to the same components, and the size of each component in the drawings may be exaggerated for clarity and convenience of description. The terms first, second, etc. may be used to describe various components, but the components should not be limited by terms. Terms are used only for the purpose of distinguishing one component from another component.

The singular expression includes plural expressions unless the context clearly implies otherwise. In addition, when a part "includes" a component, this means that it may further include other components, not excluding other components unless otherwise opposed. In the drawings, the size or thickness of each component may be exaggerated for clarity. In addition, when a predetermined material layer is described as being present on a substrate or another layer, the material layer may be directly in contact with the substrate or another layer, or another third layer may be present therebetween. In addition, since the material forming each layer in the following embodiment is exemplary, other materials may be used.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Further, the terms "unit", "module" or the like mean a unit that processes at least one function or operation, which may be implemented in hardware or software or implemented in a combination of hardware and software.

The specific implementations described are examples and do not limit the technical scope in any way. For simplicity of the specification, descriptions of conventional electronic configurations, control systems, software, and other functional aspects of the systems may be omitted. In addition, the connection or connection members of lines between the components shown in the drawings exemplarily represent functional connection and/or physical or circuit connections, and may be replaceable or represented as various additional functional connections, physical connections, or circuit connections in an actual device.

The use of the term "the" and similar indicative terms may correspond to both singular and plural.

The operations constituting the method may be performed in an appropriate order unless there is an explicit mention that the operations should be performed in the order described. In addition, the use of all illustrative terms (e.g., etc.) is simply intended to detail technical ideas and, unless limited by the claims, the scope of rights is not limited due to the terms.

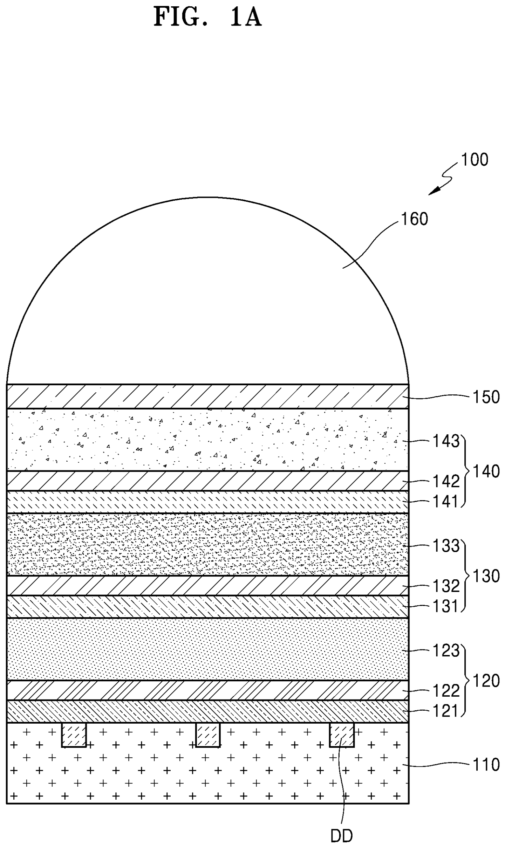

FIG. 1A is a diagram illustrating a display device according to one or more embodiments.

A display device 100 includes a backplane substrate 110, a first epitaxial structure 120, a second epitaxial structure 130, a third epitaxial structure 140, sequentially stacked on the backplane substrate 110 in a direction perpendicular to the backplane substrate 110, and a lens 160 provided on the third epitaxial structure 140. In addition, an anti-reflection layer 150 may be provided between the third epitaxial structure 140 and the lens 160.

The backplane substrate 110 may include at least one drive device DD. At least one drive device DD is for electrically driving the first epitaxial structure 120, the second epitaxial structure 130, and the third epitaxial structure 140, and may include, for example, a transistor, a thin film transistor, or a high electron mobility transistor (HEMT). However, the drive device DD is not limited thereto, and may further include a capacitor.

The first epitaxial structure 120 may include a first conductivity-type semiconductor layer 121, an active layer 122, and a second conductivity-type semiconductor layer 123, the second epitaxial structure 130 may include a first conductivity-type semiconductor layer 131, an active layer 132, and a second conductivity-type semiconductor layer 133, and the third epitaxial structure 140 may include a first conductivity-type semiconductor layer 141, an active layer 142, and a second conductivity-type semiconductor layer 143. The first epitaxial structure 120 may be configured to emit first wavelength light, the second epitaxial structure 130 may be configured to emit second wavelength light, and the third epitaxial structure 140 may be configured to emit third wavelength light. The first wavelength light, the second wavelength light, and the third wavelength light may have different wavelengths.

For example, each of the first conductivity-type semiconductor layers 121, 131, and 141 may include a p-type semiconductor. Alternatively, each of the first conductivity-type semiconductor layers 121, 131, and 141 may include an n-type semiconductor. Each of the first conductivity-type semiconductor layers 121, 131, and 141 may include a group III-V-based p-type semiconductor, for example, p-GaN, p-InGaN, p-AlInGaN, or p-AlGalnP. Each of the first conductivity-type semiconductor layers 121, 131, and 141 may have a monolayer or multilayer structure.

The active layers 122, 132, and 142 may be provided on the top surfaces of the first conductivity-type semiconductor layers 121, 131, and 141, respectively. The active layers 122, 132, and 142 may generate light while electrons and holes are combined with each other. The active layer 122 of the first epitaxial structure 120 may include a material emitting light of a first wavelength, for example, red wavelength light. The active layer 132 of the second epitaxial structure 130 may include a material emitting light of a second wavelength, for example, green wavelength light. The active layer 142 of the third epitaxial structure 140 may include a material emitting light of a third wavelength, for example, blue wavelength light. However, the active layers 122, 132, and 142 are not limited thereto. Each of the active layers 122, 132, and 142 may have a multi-quantum well (MQW) structure or a single-quantum well (SQW) structure. Each of the active layers 122, 132, and 142 may include a group III-V-based semiconductor, for example, GaN, InGaN, AlInGaN, or AlGaInP. Each of the active layers 122, 132, and 142 may include, for example, a (InGaN/GaN) quantum well structure. As the content of indium (In) included in each of the active layers 122, 132, and 142 increases, the wavelength of light emitted from each of the active layers 122, 132, and 142 may increase.

The second conductivity-type semiconductor layers 123, 133, and 143 may be provided on top surfaces of the active layers 122, 132, and 142, respectively. Each of the second conductivity-type semiconductor layers 123, 133, and 143 may include, for example, an n-type semiconductor. Alternatively, each of the second conductivity-type semiconductor layers 123, 133, and 143 may include an n-type semiconductor. Each of the second conductivity-type semiconductor layers 123, 133, and 143 may include a group III-V-based n-type semiconductor, for example, n-GaN, n-InGaN, n-AlInGaN, or n-AIGaInP. Each of the second conductivity-type semiconductor layers 123, 133, and 143 may have a monolayer structure or a multilayer structure.

Light emitted from the first epitaxial structure 120, the second epitaxial structure 130, and the third epitaxial structure 140 may be emitted upward. Light emitted upward may pass through the anti-reflection layer 150 and enter the lens 160.

The anti-reflection layer 150 may include a material that reduces or prevents reflection by suppressing light from being reflected downward to cause a decrease in the amount of light to be emitted when light emitted from the first epitaxial structure 120, the second epitaxial structure 130, and the third epitaxial structure 140 is emitted upward. The display device 100 has a vertical stack structure in which the first epitaxial structure 120, the second epitaxial structure 130, and the third epitaxial structure 140 are stacked in a direction perpendicular to the backplane substrate 110. Therefore, the first wavelength light, the second wavelength light, and the third wavelength light respectively emitted from the first epitaxial structure 120, the second epitaxial structure 130, and the third epitaxial structure 140 pass through the anti-reflection layer 150 together. In other words, the anti-reflection layer 150 may reflect and transmit the first wavelength light, the second wavelength light, and the third wavelength light together. The anti-reflection layer 150 may have different reflectance or transmittance depending on wavelengths. In addition, the reflectance of the anti-reflection layer 150 may vary depending on the constituent material and thickness thereof. Since the display device 100 according to one or more embodiments has a vertical stack structure, the anti-reflection layer 150 needs to be designed to increase transmittance for each of the first wavelength light, the second wavelength light, and the third wavelength light. By adjusting the constituent material and thickness of the anti-reflection layer 150, the reflectance of each of the first wavelength light, the second wavelength light, and the third wavelength light may be lowered, and the transmittance thereof may be increased. The anti-reflection layer 150 may include a material having a refractive index in a range of 1.7 to 2.1. The anti-reflection layer 150 may have a thickness in a range of 75 nm to 110 nm. When the anti-reflection layer 150 satisfies these conditions, the transmittance of each of the first wavelength light, the second wavelength light, and the third wavelength light may include 4 % or more. Transmittances of the first wavelength light, the second wavelength light, and the third wavelength light through the anti-reflection layer 150 may include transmittances in ranges of 5 % or more or 6 % or more, 15 % or less or 13 % or less, and 10 % or less, respectively. Here, the transmittance represents a ratio of the transmittance when there is the anti-reflection layer 150 to the transmittance when there is no anti-reflection layer. For example, the anti-reflection layer 150 may include Al₂O₃, SiN, TiO₂, ZrO₂, ZnO, Ta₂O₃, or SiON. The anti-reflection layer 150 may transmit light of a plurality of wavelengths with a high transmittance in common.

The first wavelength light, the second wavelength light, and the third wavelength light having passed through the anti-reflection layer 150 may be incident on the lens 160 with high light emission efficiency, and may be condensed by the lens 160.

As described above, since the display device 100 according to one or more embodiments has a vertical stack structure, an area forming one pixel that emits light of a plurality of wavelengths may be reduced. In addition, the display device 100 may display color images with high light efficiency and high resolution by increasing the light emission efficiency for each light of multiple wavelengths, including the anti-reflection layer 150.

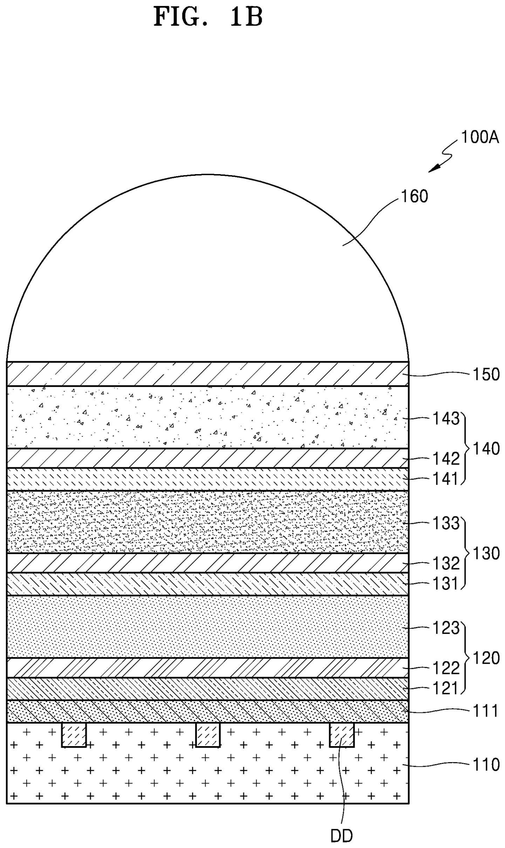

FIG. 1B is a diagram illustrating an example of further including a reflective layer in the display device illustrated in FIG. 1A according to one or more embodiments. In FIG. 1B, components having the same member number as in FIG. 1A have substantially the same configuration and action as those described in FIG. 1A, and thus a detailed description thereof may be omitted.

Referring to FIG. 1B, a display device 100A may include a reflective layer 111 between a backplane substrate 110 and a first epitaxial structure 120. The reflective layer 111 may include, for example, Ag, Au, Al, Cr, or Ni, or an alloy thereof. However, the reflective layer 111 is not limited thereto. When the light emitted from the first epitaxial structure 120, the second epitaxial structure 130, and the third epitaxial structure 140 is emitted downward, the reflective layer 111 reflects the light emitted downward so that the light is emitted toward the upper portion of the display device 100A again, thereby increasing light emission efficiency.

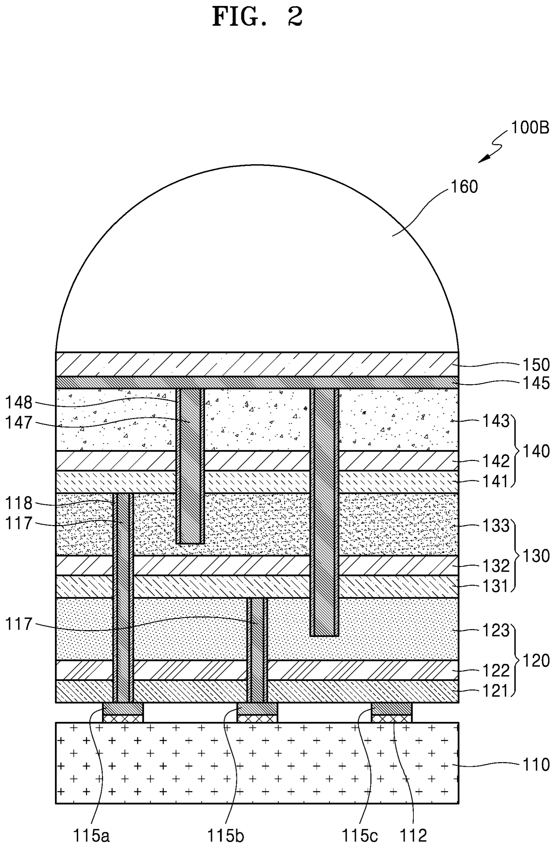

FIG. 2 is a diagram illustrating an example of adding an electrode structure to a display device according to one or more embodiments.

The display device 100B has an electrode structure added to the display device 100 shown in FIG. 1A. In FIG. 2, components having the same member number as in FIG. 1A have substantially the same configuration and action as those described in FIG. 1A, and thus a detailed description thereof may be omitted.

In the display device 100B, a first p-type electrode 115a, a second p-type electrode 115b, and a third p-type electrode 115c may be provided to be spaced apart from each other (e.g., laterally spaced apart), and may be between a backplane substrate 110 and a first epitaxial structure 120. A pad 112 may be provided between each of the first p-type electrode 115a, the second p-type electrode 115b, and the third p-type electrode 115c and the backplane substrate 110. The first p-type electrode 115a, the second p-type electrode 115b, and the third p-type electrode 115c may include at least one of Au, Cu, Ni, Ag, Cr, W, Al, Pt, Sn, Pb, Fe, Ti, and Mo, or may include any one of ITO, ZrB, ZnO, InO, and SnO.

The first p-type electrode 115a may be electrically connected to a first conductivity-type semiconductor layer 141 of a third epitaxial structure 140 by a first via electrode 117. The second p-type electrode 115b may be electrically connected to a first conductivity-type semiconductor layer 131 of a second epitaxial structure 130 by another first via electrode 117. The third p-type electrode 115c may be directly connected to the first conductivity-type semiconductor layer 121 of the first epitaxial structure 120.

An n-type electrode 145 may be provided between the second conductivity-type semiconductor layer 143 of the third epitaxial structure 140 and the anti-reflection layer 150. The n-type electrode 145 may include a transparent electrode through which light is transmitted. The n-type electrode 145 may be electrically connected to the second conductivity-type semiconductor layer 123 of the first epitaxial structure 120 and the second conductivity-type semiconductor layer 133 of the second epitaxial structure 130 by respective second via electrodes 147. The second conductivity-type semiconductor layer 143 of the third epitaxial structure 140 may be directly connected to the n-type electrode 145.

The display device 100B may further include a first insulating layer 118 provided to surround a sidewall of each of the first via electrodes 117 and a second insulating layer 148 provided to surround a sidewall of each of the second via electrodes 147. The first insulating layer 118 may insulate the first via electrode 117 from each of the first epitaxial structure 120 and the second epitaxial structure 130. The second insulating layer 148 may insulate the second via electrode 147 from each of the third epitaxial structure 140 and the second epitaxial structure 130. The first insulating layer 118 and the second insulating layer 148 may include an insulating material. The first insulating layer 118 and the second insulating layer 148 may include, for example, SiO₂, Si₃N₄, HfO₂, or Al₂O₃.

The electrode structure described above may be a so-called vertical electrode structure. However, the electrode structure of the display device according to one or more embodiments is not limited thereto, and may have a horizontal electrode structure.

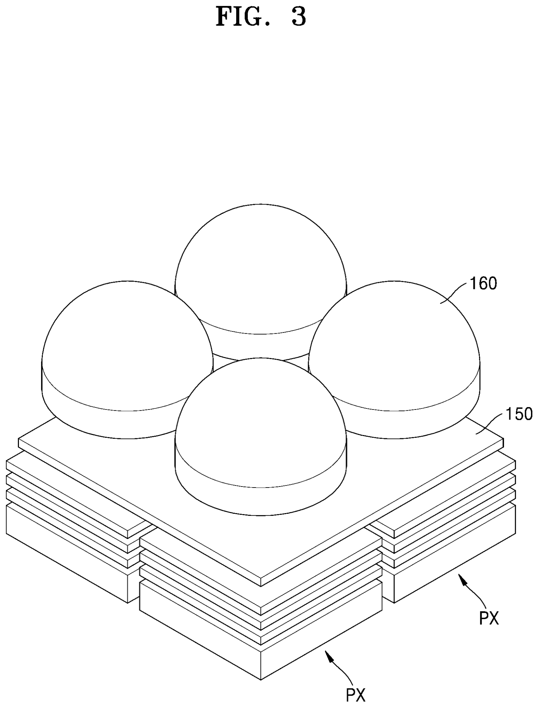

FIG. 3 is a diagram illustrating an example in which an anti-reflection layer is commonly provided for a plurality of pixels in a display device according to one or more embodiments. FIG. 3 illustrates that a display device according to one or more embodiments includes a plurality of pixels PX. The plurality of pixels PX may be arranged to be spaced apart from each other. Each of the plurality of pixels PX may have a structure shown in FIG. 1A, and here, for convenience, the structure is briefly shown in FIG. 3. Each of the plurality of pixels PX may include the first epitaxial structure 120, the second epitaxial structure 130, and the third epitaxial structure 140 shown in FIG. 1, and may have a structure in which the anti-reflection layer 150 is connected to a plurality of pixels PX as a single body. That is, in FIG. 3, the anti-reflection layer 150 is shared as a single body between the plurality of pixels. In this way, the manufacturing process may be simplified by forming the anti-reflection layer 150 as a single layer.

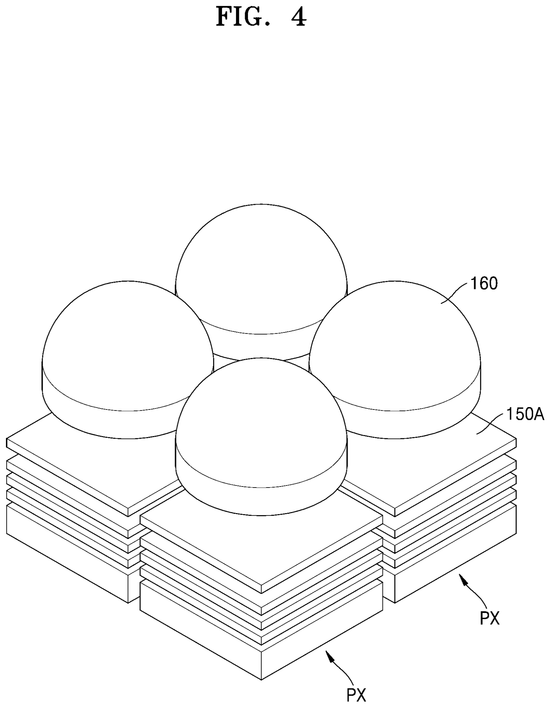

FIG. 4 is a diagram illustrating an example in which an anti-reflection layer is separately provided for each of a plurality of pixels in a display device according to one or more embodiments. That is, FIG. 4 illustrates an example in which anti-reflection layers 150A are separately provided for a plurality of pixels PX, respectively. As described above, the anti-reflection layers 150A may be spaced apart from the plurality of pixels PX, respectively. In other words, the anti-reflection layer 150 may be partitioned into a plurality of anti-reflection layer portions 150A, with each partitioned anti-reflection layer portion 150A individually corresponding to a pixel PX.

Next, an operation effect of the display device according to one or more embodiments is described.

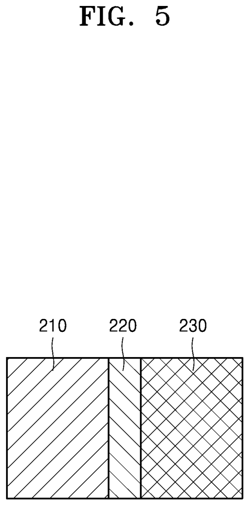

FIG. 5 is a diagram illustrating an anti-reflection layer, a first layer provided on one surface of the anti-reflection layer, and a second layer provided on the other surface of the anti-reflection layer according to one or more embodiments. That is, FIG. 5 schematically illustrates an anti-reflection layer 220, a first layer 210 on one side of the anti-reflection layer 220, and a second layer 230 on the other side of the anti-reflection layer 220. The first layer 210 may be, for example, the second conductivity-type semiconductor layer 143 of the third epitaxial structure 140 in the display device 100 shown in FIG. 1A, and the second layer 230 may be the lens 160. With respect to such a three-layer structure, the transmittance of light was simulated while changing the refractive index and thickness of the anti-reflection layer 220.

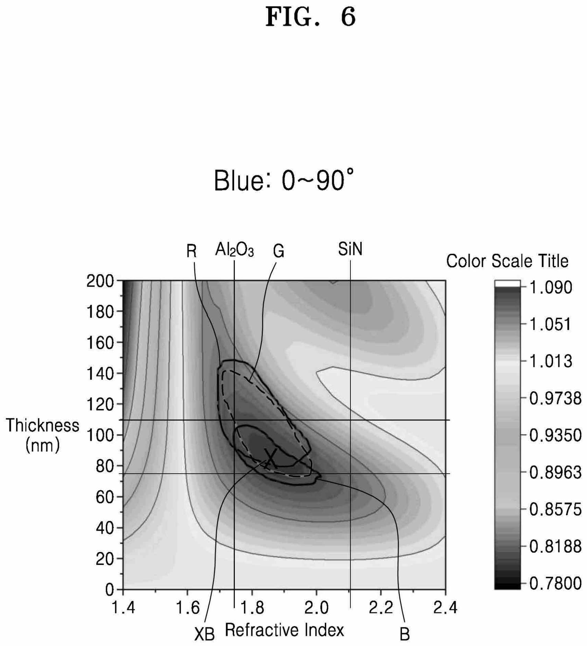

FIG. 6 is a graph illustrating a result of simulating transmittance of blue light (Blue) incident on the anti-reflection layer 220 at an incident angle of 0 to 90 degrees according to one or more embodiments. In the graph of FIG. 6, the horizontal axis represents the refractive index and the vertical axis represents the thickness. The transmittance for blue light was simulated while the refractive index was changed in a range of 1.4 to 2.4 and the thickness was changed in a range of 0 nm to 200 nm. The color scale title on the right side of the graph represents the transmittance index, where the transmittance represents the ratio of the transmittance when there is an anti-reflection layer to the transmittance when there is no anti-reflection layer. In other words, when the anti-reflection layer is provided, the transmittance may be improved. The higher the altitude, the higher the transmittance and the lower the reflectance. Referring to FIG. 6, an area represented by B represents an area in which the transmittance of blue light is high, and an area represented by XB represents an area in which the transmittance of blue light is maximum. In FIG. 6, an area G indicated by the dotted line represents an area with a high transmittance of green light to be described later, and an area R region indicated by the long and short dash line represents an area with a high transmittance of red light to be described later.

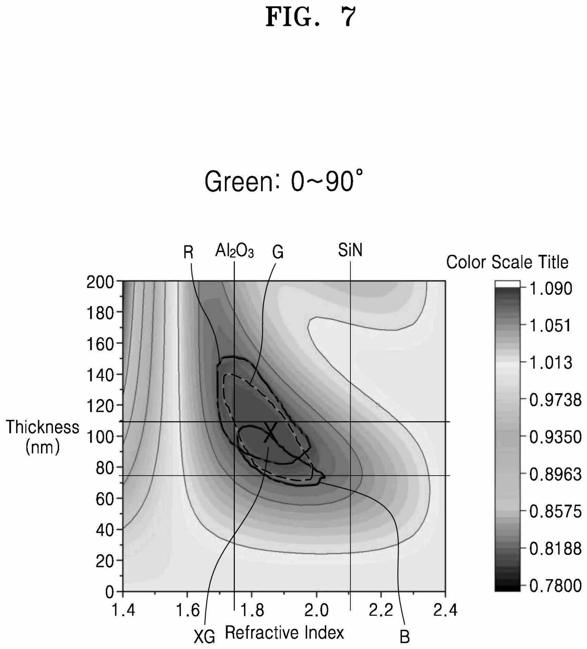

FIG. 7 is a graph illustrating a result of simulating transmittance of green light (Green) incident on the anti-reflection layer 220 at an incident angle of 0 to 90 degrees according to one or more embodiments. Referring to FIG. 7, an area represented by G represents an area in which the transmittance of green light is high, and an area represented by XG represents an area in which the transmittance of green light is maximum.

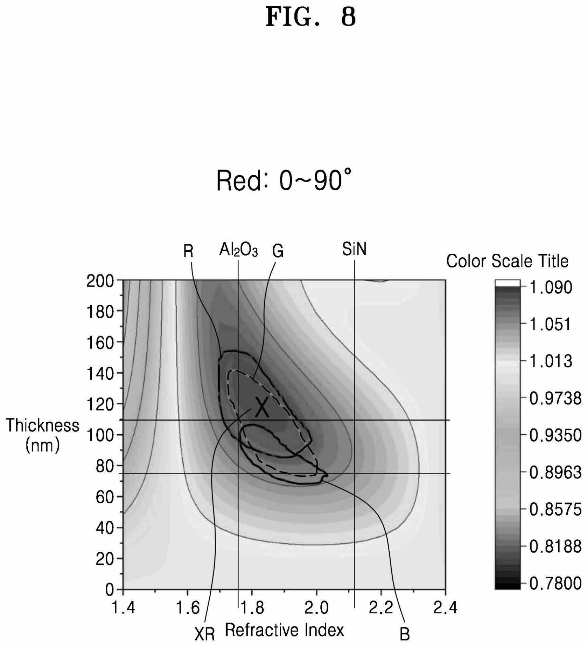

FIG. 8 is a graph illustrating a result of simulating transmittance of red light (Red) incident on the anti-reflection layer 220 at an incident angle of 0 to 90 degrees according to one or more embodiments. Referring to FIG. 8, an area represented by R represents an area in which the transmittance of red light is high, and an area represented by XR represents an area in which the transmittance of red light is maximum.

Referring to FIGS. 6, 7, and 8, an area having high transmittance all for blue light, green light, and red light may be derived. For convenience of description, areas B, G, and R having high transmittance are shown together in FIGS. 6, 7, and 8, and based on this, the anti-reflection layer 220 of FIG. 5 may have a refractive index in a range of 1.7 to 2.1. In addition, the thickness of the anti-reflection layer 220 may be in a range of 75 nm to 110 nm.

In the display device 100, external quantum efficiency (EQE) and internal quantum efficiency (IQE) of each of the active layers 122, 132, and 142 may decrease as the light emission wavelength increases. In addition, as the content of indium of each of the active layers 122, 132, and 142 increases, defects due to lattice mismatch may increase. Accordingly, the light efficiency of red light among blue light, green light, and red light may be relatively low. Therefore, the thickness and refractive index of the anti-reflection layer 220 may be determined based on an area having a high transmittance of red light among blue light, green light, and red light.

As described above, the anti-reflection layer 150 of the display device 100 according to one or more embodiments has a refractive index in a range of 1.7 to 2.1 and a thickness in a range of 75 nm to 110 nm, and thus, the anti-reflection layer 150 may have a high transmittance in common for blue light, green light, and red light, and may be usefully applied in a vertical stack structure that uses a common area for each color light in one pixel.

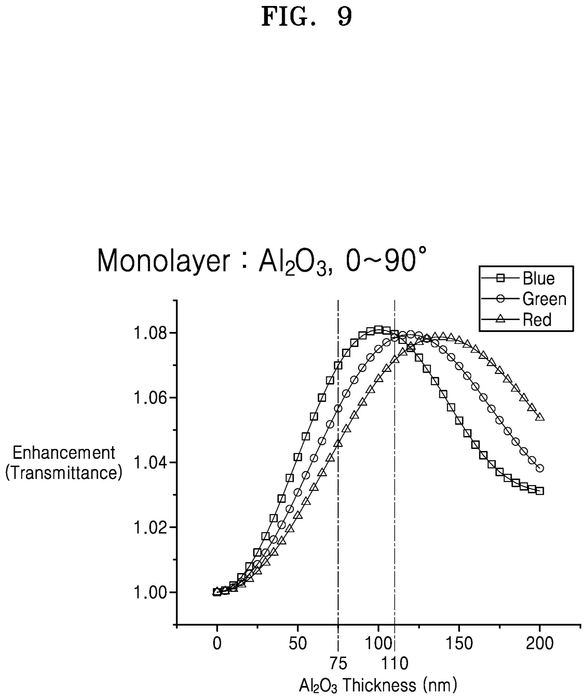

FIG. 9 is a graph illustrating simulation of transmittance according to thickness for an anti-reflection layer including an Al₂O₃ monolayer according to one or more embodiments. Here, the transmittance represents a ratio of the transmittance when there is the anti-reflection layer to the transmittance when there is no anti-reflection layer. The refractive index of Al₂O₃ is approximately 1.76. Transmittance for each of blue light, green light, and red light in the thickness range of 75 nm to 110 nm was improved in a range of 4 % to 8 %.

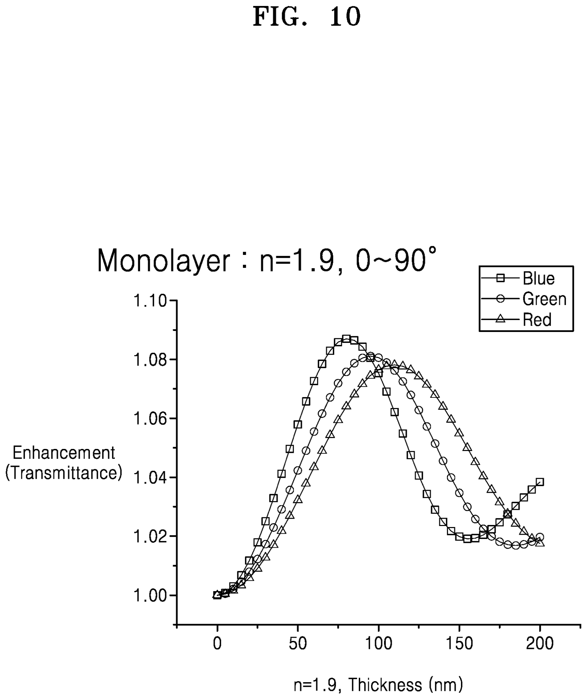

FIG. 10 is a graph illustrating simulation of transmittance according to thickness for an anti-reflection layer including a monolayer having a refractive index n (n=1.9) according to one or more embodiments. Transmittance for each of blue light, green light, and red light in the thickness range of 75 nm to 110 nm was improved in a range of 6 % to 9 %.

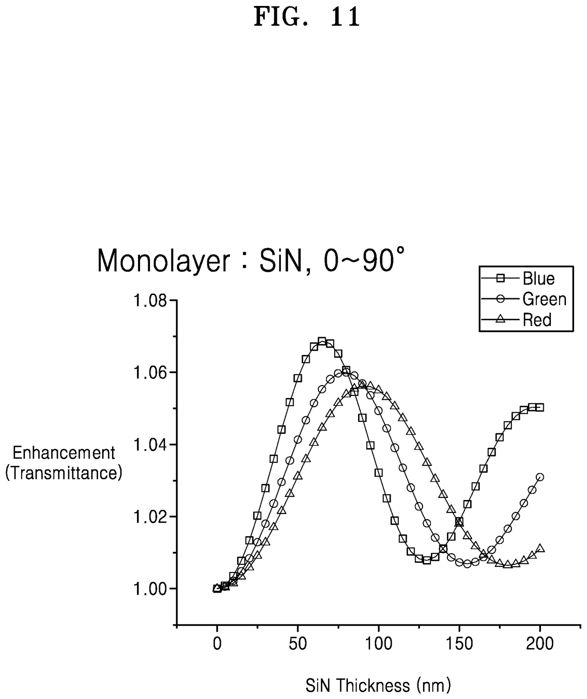

FIG. 11 is a graph illustrating simulation of transmittance according to thickness for an anti-reflection layer including a SiN monolayer according to one or more embodiments. The refractive index of SiN is approximately 2.1. Transmittance for each of blue light, green light, and red light in the thickness range of 75 nm to 110 nm was improved in a range of 2 % to 5 %.

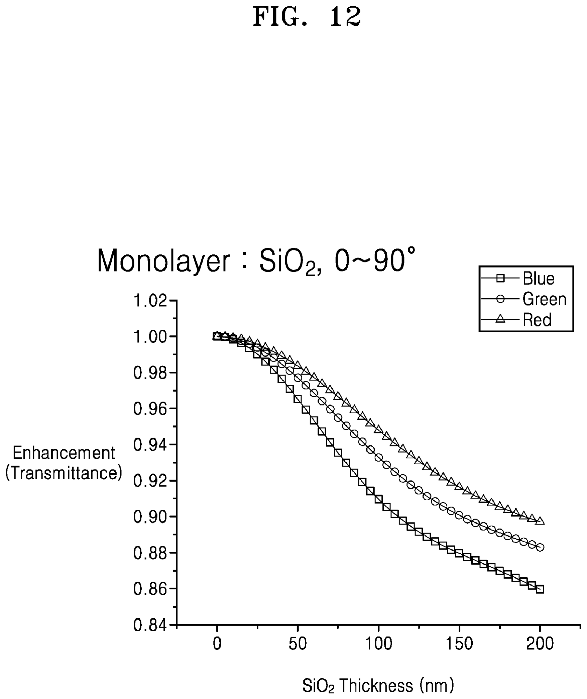

FIG. 12 is a graph illustrating simulation of transmittance according to thickness for a SiO₂ monolayer as a comparative example. The refractive index of SiO₂ is approximately 1.46. The SiO₂ monolayer shows lower transmittance than the case without the SiO₂ monolayer, regardless of thickness.

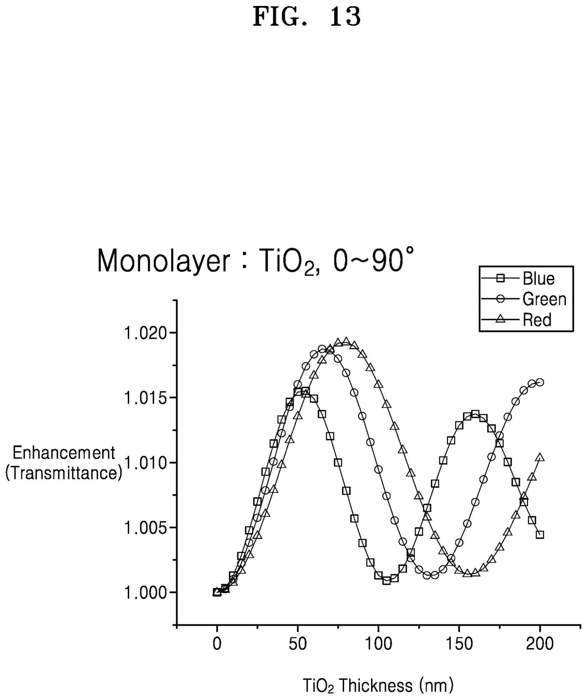

FIG. 13 is a graph illustrating simulation of transmittance according to thickness for a TiO₂ monolayer as another comparative example. The refractive index of TiO₂ is approximately 2.4. The TiO₂ monolayer showed very little improvement to a degree of less than 2 % in the transmittance of blue light, green light, and red light in the thickness range of 75 nm to 110 nm.

Referring to FIG. 5, when the refractive index of the first layer 210 is n1, the refractive index of the anti-reflection layer 220 is n2, and the refractive index of the second layer 230 is n3, where n1>n2>n3. In this way, the transmittance of light may increase when a material whose refractive index decreases is included in a direction in which light is directed to the lens 160 from a layer adjacent to the anti-reflection layer 220, that is, in a direction in which light is emitted to the outside. When the layer structure shown in FIG. 5 is applied to FIG. 1A, and when the refractive index of the second conductivity-type semiconductor layer 143 of the third epitaxial structure 140 is n1, the refractive index of the anti-reflection layer 150 is n2, and the refractive index of the lens 160 is n3, wherein n1>n2>n3.

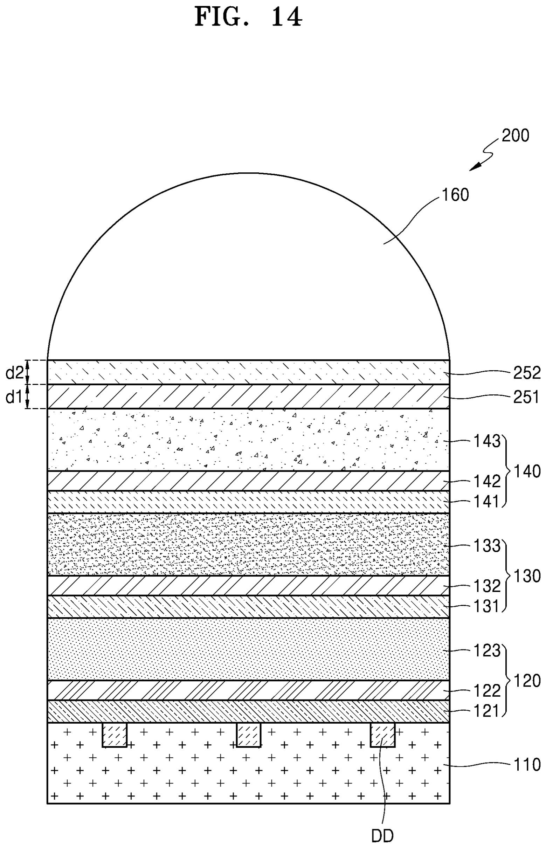

FIG. 14 is a diagram illustrating an example in which a display device according to one or more embodiments includes two anti-reflection layers. In FIG. 14, components having the same member number as in FIG. 1A have substantially the same configuration and action as those described in FIG. 1A, and thus a detailed description thereof may be omitted.

Referring to FIG. 14, a display device 200 may include a first anti-reflection layer 251 and a second anti-reflection layer 252 between a third epitaxial structure 140 and a lens 160. The first anti-reflection layer 251 and the second anti-reflection layer 252 may be sequentially arranged from the third epitaxial structure 140. The first anti-reflection layer 251 may include a first refractive index, and the second anti-reflection layer 252 may include a second refractive index less than the first refractive index. For example, the first anti-reflection layer 251 may include a refractive index of 1.9 or more, and the second anti-reflection layer 252 may include a refractive index of 1.9 or less. For example, the first anti-reflection layer 251 may include a refractive index of 1.9 to 2.5, and the second anti-reflection layer 252 may include a refractive index of 1.4 to 1.9. However, the refractive indices of the first anti-reflection layer 251 and the second anti-reflection layer 252 are not limited thereto. A thickness d1 of the first anti-reflection layer 251 and a thickness d2 of the second anti-reflection layer 252 may each have a thickness greater than 0 and equal to or less than 200 nm.

In addition, when a refractive index of the second conductivity-type second semiconductor layer 143 having the third epitaxial structure 140 is n1, a refractive index of the first anti-reflection layer 251 is n21, a refractive index of the second anti-reflection layer 252 is n22, and a refractive index of the lens 160 is n3, where n1>n21>n22>n3.

The light transmittance may be increased by adjusting the refractive index and thickness of the first anti-reflection layer 251 and the second anti-reflection layer 252 having a dual layer structure, thereby increasing the light emission efficiency of the display device 200.

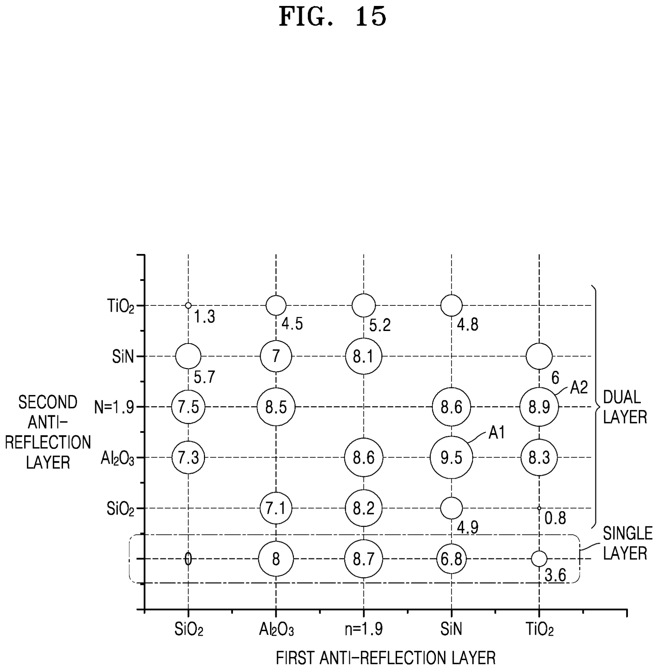

FIG. 15 is a diagram illustrating a simulation result of transmittance of blue light while changing refractive indices and thicknesses of first and second anti-reflection layers according to one or more embodiments. That is, FIG. 15 shows a result of simulating transmittance of blue light while changing refractive indices and thicknesses of first and second anti-reflection layers 251 and 252. The horizontal axis represents the refractive index of the first anti-reflection layer 251, and the vertical axis represents the refractive index of the second anti-reflection layer 252. For the refractive index, the material names SiO₂, Al₂O₃, SiN, and TiO₂ are used instead of the refractive indices. The refractive index of SiO₂ is approximately 1.46, the refractive index of Al₂O₃ is approximately 1.76, the refractive index of SiN is approximately 2.1, and the refractive index of TiO₂ is approximately 2.4. FIG. 15 shows a maximum value among simulation results of transmittance as a numerical value at corresponding coordinates, while changing the thickness in a dual layer structure anti-reflection layer made of corresponding materials on a horizontal axis and a vertical axis. For example, in FIG. 15, the coordinate A1 shows that the maximum transmittance value is 9.5 % in the simulation of the first anti-reflection layer 251 including SiN and the second anti-reflection layer 252 including Al₂O₃. In addition, the coordinate A2 shows that the maximum transmittance value is 8.9 % in the simulation of the first anti-reflection layer 251 including TiO₂ and the second anti-reflection layer 252 including a material with a refractive index n (n=1.9). The size of the circle shown in each coordinate in the graph is a relative representation of the transmittance value. That is, the larger the size of the circle, the greater the transmittance.

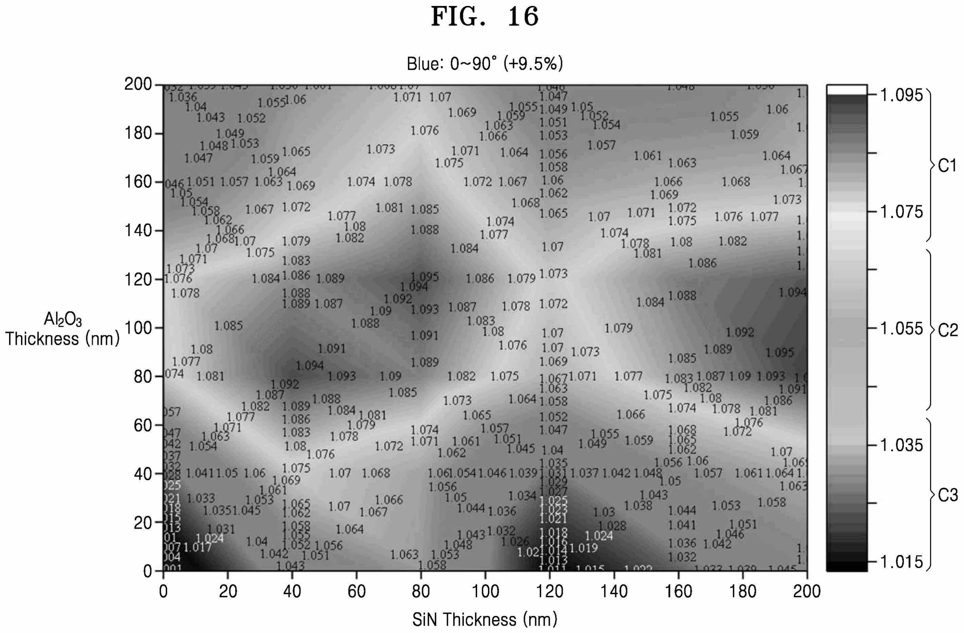

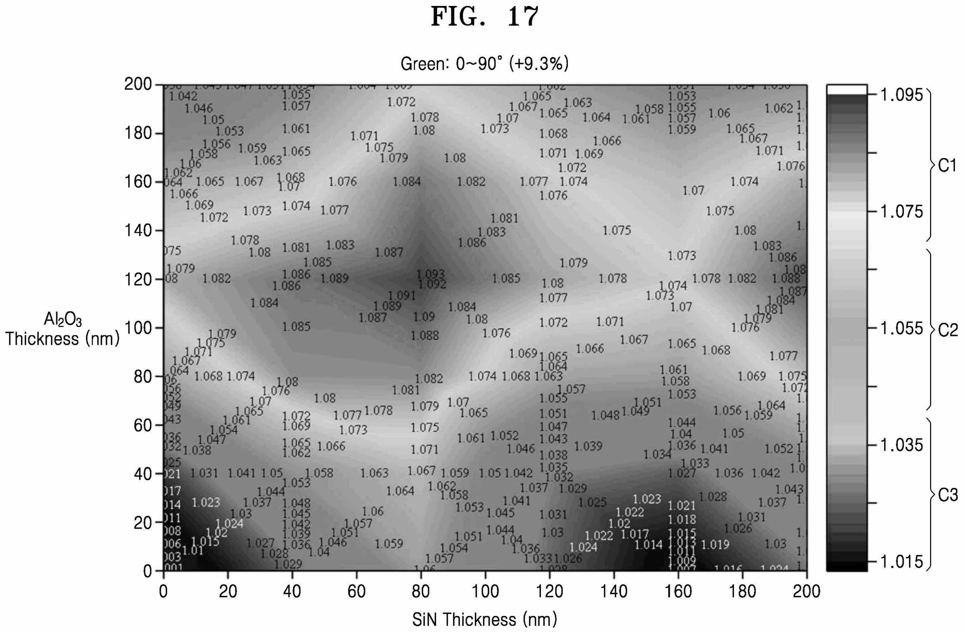

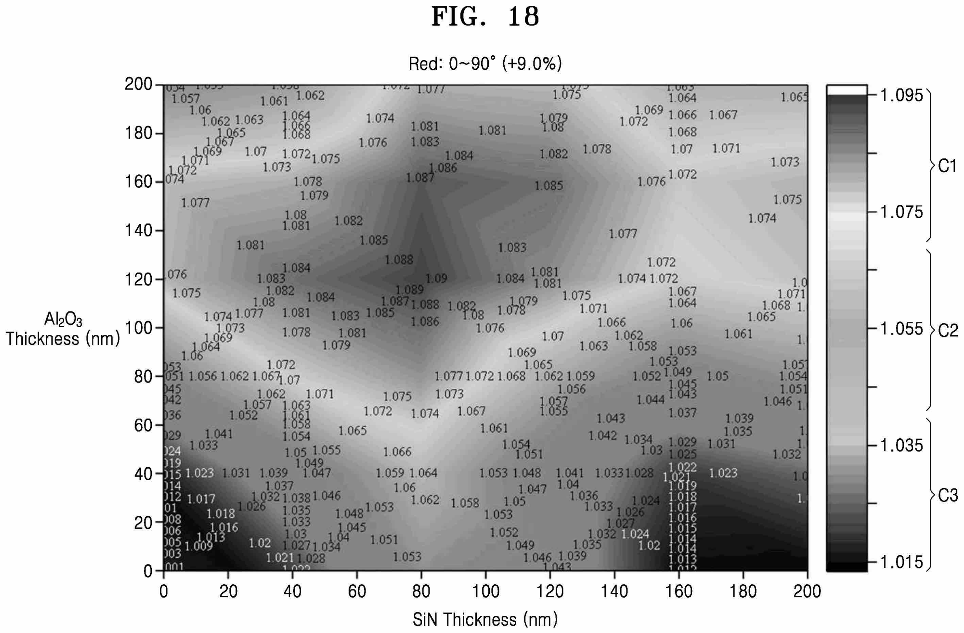

FIG. 16 is a diagram illustrating a simulation result of transmittance of blue light while changing a thickness of a first anti-reflection layer including SiN and a thickness of a second anti-reflection layer including Al₂O₃ in a range of 0 nm to 200 nm according to one or more embodiments. FIG. 17 is a diagram illustrating a simulation result for transmittance of green light while changing a thickness of a first anti-reflection layer including SiN and a thickness of a second anti-reflection layer including Al₂O₃ in a range of 0 nm to 200 nm according to one or more embodiments. FIG. 18 is a diagram illustrating a simulation result for transmittance of red light while changing a thickness of a first anti-reflection layer including SiN and a thickness of a second anti-reflection layer including Al₂O₃ in a range of 0 nm to 200 nm according to one or more embodiments.

FIGS. 16, 17, and 18 illustrate detailed simulation results of the coordinate A1 of FIG. 15. FIG. 16 illustrates a simulation of blue light, FIG. 17 illustrates a simulation of green light, and FIG. 18 illustrates a simulation of red light. Here, the transmittance was simulated by changing the thicknesses of the first anti-reflection layer 251 including SiN and the second anti-reflection layer 252 including Al₂O₃ in a range of 0 to 200 nm. The color scale title represents an indicator of transmittance, with transmittances C1, C2, and C3 indicating C1 > C2 > C3. The numerical values shown in the coordinates in FIGS. 16, 17, and 18 indicate transmittance in the corresponding thickness structure. Referring to FIG. 16, for example, when the first anti-reflection layer 251 including SiN has a thickness of approximately 45 nm and the second anti-reflection layer 252 including Al₂O₃ has a thickness of approximately 83 nm, the transmittance of blue light is 1.094. In other words, the transmittance is higher by about 9.4 % than that of the case where there is no anti-reflection layer. Referring to FIG. 17, when the first anti-reflection layer 251 including SiN has a thickness of approximately 90 nm and the second anti-reflection layer 252 including Al₂O₃ has a thickness of approximately 120 nm, the transmittance of blue light is 1.093. Referring to FIG. 18, for example, when the first anti-reflection layer 251 including SiN has a thickness of approximately 90 nm and the second anti-reflection layer 252 including Al₂O₃ has a thickness of approximately 120 nm, the transmittance of red light is 1.09. Referring to FIGS. 16, 17, and 18, the thickness of the first anti-reflection layer 251 including SiN may be less than the thickness of the second anti-reflection layer 252 including Al₂O₃.

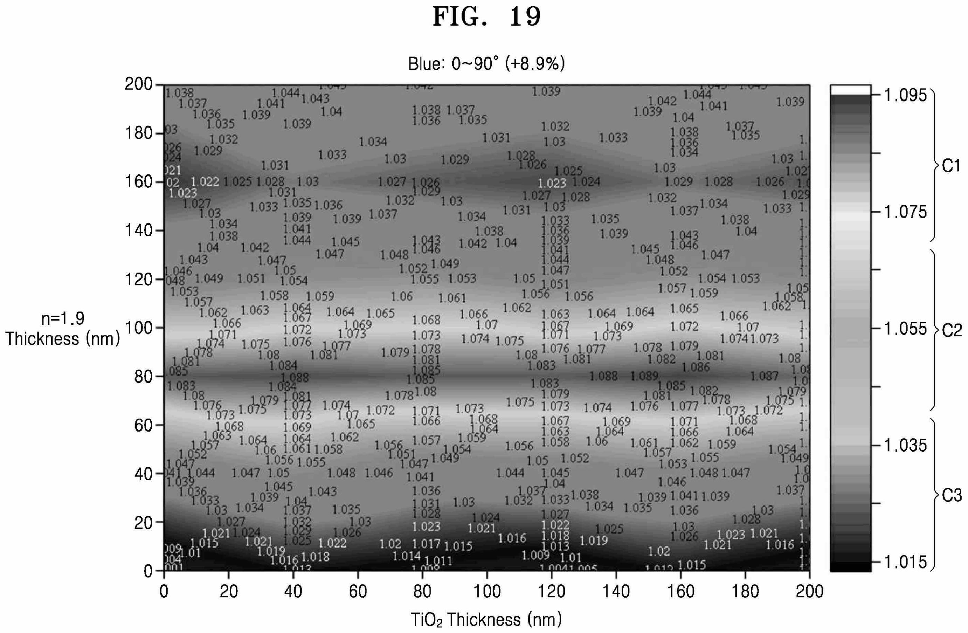

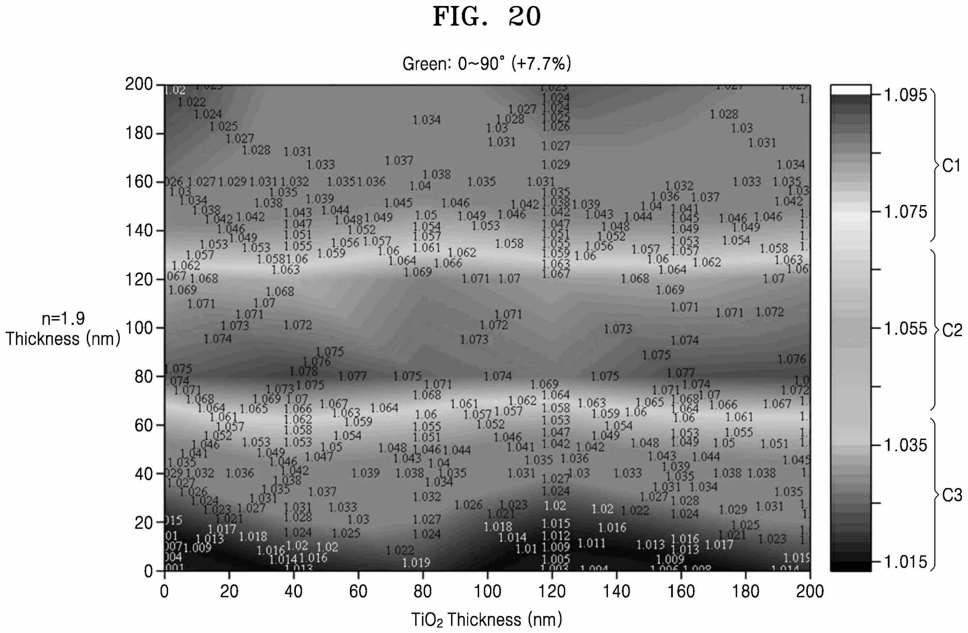

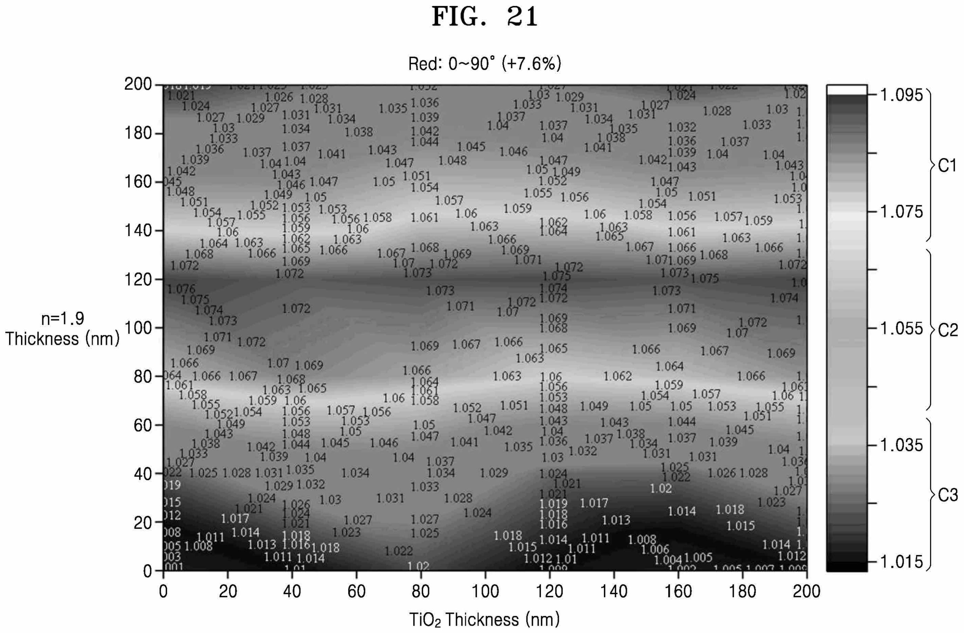

FIG. 19 is a diagram illustrating a simulation result for transmittance of blue light while changing a thickness of a first anti-reflection layer including TiO₂ and a thickness of a second anti-reflection layer including a material of a refractive index n (n=1.9) in a range of 0 nm to 200 nm according to one or more embodiments. FIG. 20 is a diagram illustrating a simulation result for transmittance of green light while changing a thickness of a first anti-reflection layer including TiO₂ and a thickness of a second anti-reflection layer including a material of a refractive index n (n=1.9) in a range of 0 nm to 200 nm according to one or more embodiments. FIG. 21 is a diagram illustrating a simulation result for transmittance of red light while changing a thickness of a first anti-reflection layer including TiO₂ and a thickness of a second anti-reflection layer including a material of a refractive index n (n=1.9) in a range of 0 nm to 200 nm according to one or more embodiments.

FIGS. 19, 20, and 21 illustrate detailed simulation results of the coordinate A2 of FIG. 15. FIG. 19 illustrates a simulation of blue light, FIG. 20 illustrates a simulation of green light, and FIG. 21 illustrates a simulation of red light. Here, the transmittance was simulated by changing the thicknesses of the first anti-reflection layer 251 including TiO₂ and the second anti-reflection layer 252 including a material with a refractive index n (n=1.9) in a range of 0 to 200 nm. The numerical values shown in the coordinates in FIGS. 19, 20, and 21 indicate transmittance in the corresponding thickness structure. Referring to FIG. 19, for example, when the first anti-reflection layer 251 including TiO₂ has a thickness of approximately 150 nm and the second anti-reflection layer 252 including a material with a refractive index n (n= =1.9) has a thickness of approximately 89 nm, the transmittance of blue light is approximately 1.089. Referring to FIG. 20, when the first anti-reflection layer 251 including TiO₂ has a thickness of approximately 60 nm and the second anti-reflection layer 252 including a material with a refractive index (n=1.9) has a thickness of approximately 80 nm, the transmittance of blue light is approximately 1.077. Referring to FIG. 21, for example, when the first anti-reflection layer 251 including TiO₂ has a thickness of approximately 10 nm and the second anti-reflection layer 252 including a material with a refractive index n (n=1.9) has a thickness of approximately 120 nm, the transmittance of red light is approximately 1.076.

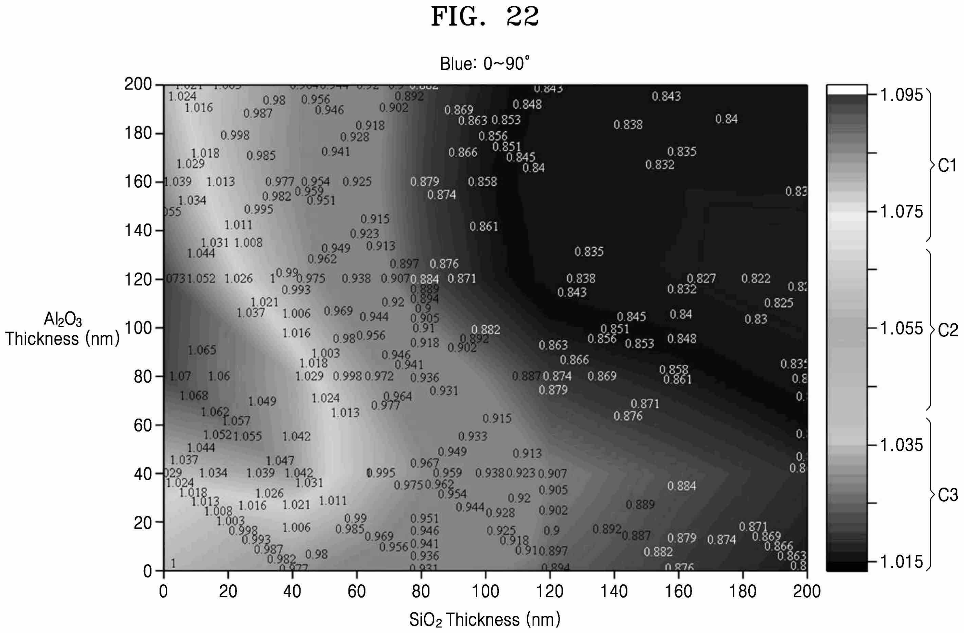

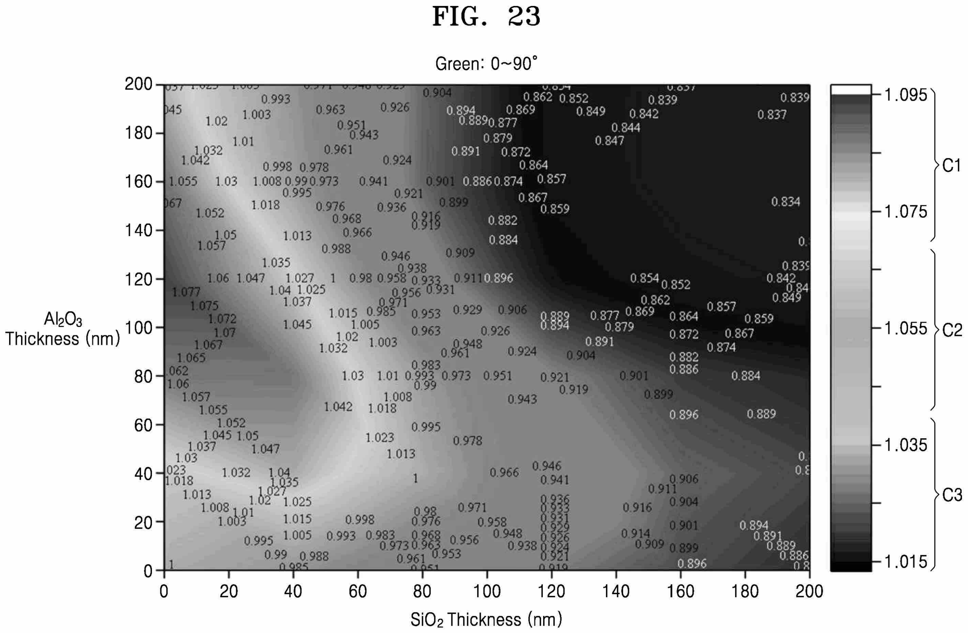

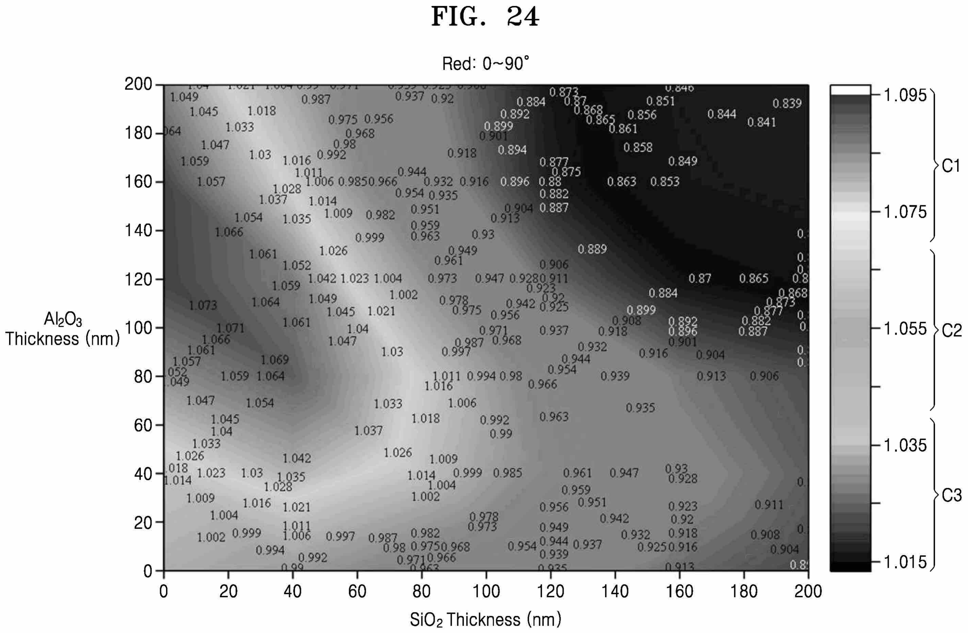

FIG. 22 is a diagram illustrating a simulation result for transmittance of blue light while changing a thickness of a first anti-reflection layer including SiO₂ and a thickness of a second anti-reflection layer including Al₂O₃ in a range of 0 nm to 200 nm according to one or more embodiments. FIG. 23 is a diagram illustrating a simulation result for transmittance of green light while changing a thickness of a first anti-reflection layer including SiO₂ and a thickness of a second anti-reflection layer including Al₂O₃ in a range of 0 nm to 200 nm according to one or more embodiments. FIG. 24 is a diagram illustrating a simulation result for transmittance of red light while changing a thickness of a first anti-reflection layer including SiO₂ and a thickness of a second anti-reflection layer including Al₂O₃ in a range of 0 nm to 200 nm according to one or more embodiments.

FIGS. 22, 23, and 24 show simulations of transmittance while changing a thickness of the first anti-reflection layer 251 including SiO₂ and a thickness of the second anti-reflection layer 252 including Al₂O₃ in a range of 0 to 200 nm. FIG. 22 shows a simulation of transmittance for blue light, FIG. 23 shows a simulation of transmittance for green light, and FIG. 24 shows a simulation of transmittance for red light. Referring back to FIG. 15, when the first anti-reflection layer 251 including SiO₂ and the second anti-reflection layer 252 including Al₂O₃ are included, the maximum transmittance of blue light is 7.3 %. FIG. 22 shows detailed simulation results for blue light. For example, when the first anti-reflection layer 251 including SiO₂ has a thickness of approximately 5 nm and the second anti-reflection layer 252 including Al₂O₃ has a thickness of approximately 120 nm, the transmittance of blue light is approximately 1.0731. FIG. 23 shows detailed simulation results for green light. For example, when the first anti-reflection layer 251 including SiO₂ has a thickness of approximately 5 nm and the second anti-reflection layer 252 including Al₂O₃ has a thickness of approximately 118 nm, the transmittance of blue light is approximately 1.077. FIG. 24 shows detailed simulation results for red light. For example, when the first anti-reflection layer 251 including SiO₂ has a thickness of approximately 10 nm and the second anti-reflection layer 252 including Al₂O₃ has a thickness of approximately 110 nm, the transmittance of blue light is approximately 1.073. Referring to FIGS. 22, 23, and 24, the thickness of the first anti-reflection layer 251 including SiO₂ may be less than the thickness of the second anti-reflection layer 252 including Al₂O₃.

As described above, the display device 200 according to one or more embodiments may include two anti-reflection layers 251 and 252 to increase each transmittance of a plurality of beams of color light.

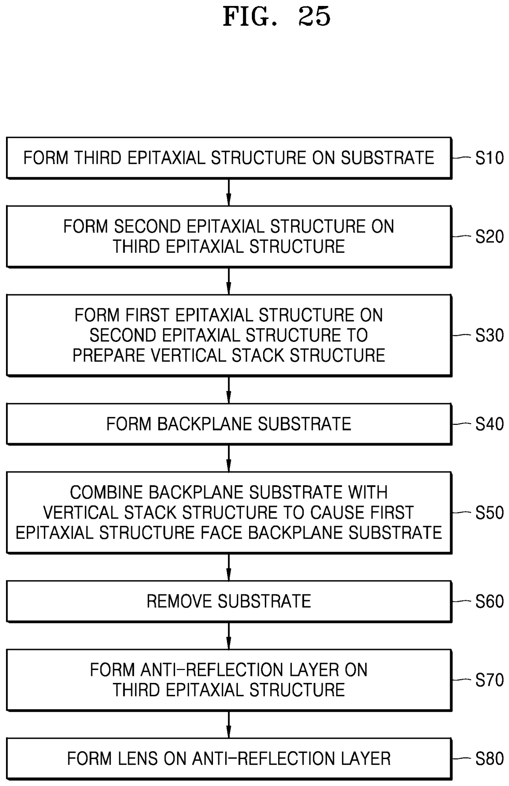

FIG. 25 is a flowchart illustrating a method of manufacturing a display device according to one or more embodiments. A method of manufacturing a display device according to one or more embodiments may include an operation S10 of forming a third epitaxial structure on a substrate, an operation S20 of forming a second epitaxial structure on the third epitaxial structure, and an operation S30 of forming a first epitaxial structure on the second epitaxial structure, thereby preparing a vertical stack structure. The substrate is a growth substrate for growing an epitaxial structure thereon, and the substrate may include, for example, silicon, sapphire, or GaAs. However, embodiments are not limited thereto and the substrate may include a material other than silicon, sapphire, or GaAs.

For example, the third epitaxial structure may emit blue light, the second epitaxial structure may emit green light, and the first epitaxial structure may emit red light. Here, the first epitaxial structure, the second epitaxial structure, and the third epitaxial structure were used by unifying names with corresponding components compared to FIG. 1. When the third epitaxial structure, the second epitaxial structure, and the first epitaxial structure are grown on the substrate, the third epitaxial structure formed first on the substrate may have relatively more defects than the first epitaxial structure formed later. Therefore, it is preferable that the first epitaxial structure for emitting red light with relatively low light efficiency be formed last.

Then, a backplane substrate is formed in operation S40. The backplane substrate may include at least one drive device. The vertical stack structure is combined with the backplane substrate by causing the first epitaxial structure to face the backplane substrate, by turning the vertical stack structure upside down in operation S50. The vertical stack structure may have a structure in which the first epitaxial structure, the second epitaxial structure, and the third epitaxial structure are sequentially stacked in a vertical direction from the backplane substrate. As described above, the first epitaxial structure emitting red light may be formed later in the growth process, and accordingly, the vertical stack structure is reversed and bonded to the backplane substrate, so that the first epitaxial structure may be located on the backplane substrate. In this way, after the vertical stack structure is coupled to the backplane substrate, the substrate may be removed in operation S60. Further, an anti-reflection layer may be formed on the third epitaxial structure in operation S70. A lens may be formed on the anti-reflection layer in operation S80.

In this way, a display device including an anti-reflection layer may be manufactured. The operation of forming the anti-reflection layer may include an operation of forming a first anti-reflection layer and an operation of forming a second anti-reflection layer.

Each of the forming of the first epitaxial structure, the forming of the second epitaxial structure, and the forming of the third epitaxial structure may include forming a first conductivity-type semiconductor layer, forming an active layer, and forming a second conductivity semiconductor layer.

As described above, the display device according to one or more embodiments may include an anti-reflection layer capable of increasing transmittance in common for each of blue light, green light, and red light. The anti-reflection layer may be configured to have an optimal transmittance in common for a plurality of beams of color light by adjusting the thickness and the refractive index of the anti-reflection layer. In this way, the display device having a vertical stack structure may increase the light emission efficiency by increasing the transmittance of each of blue light, green light, and red light without color filters. A display device with increased light emission efficiency for a plurality of beams of color light may be applied to various electronic devices.

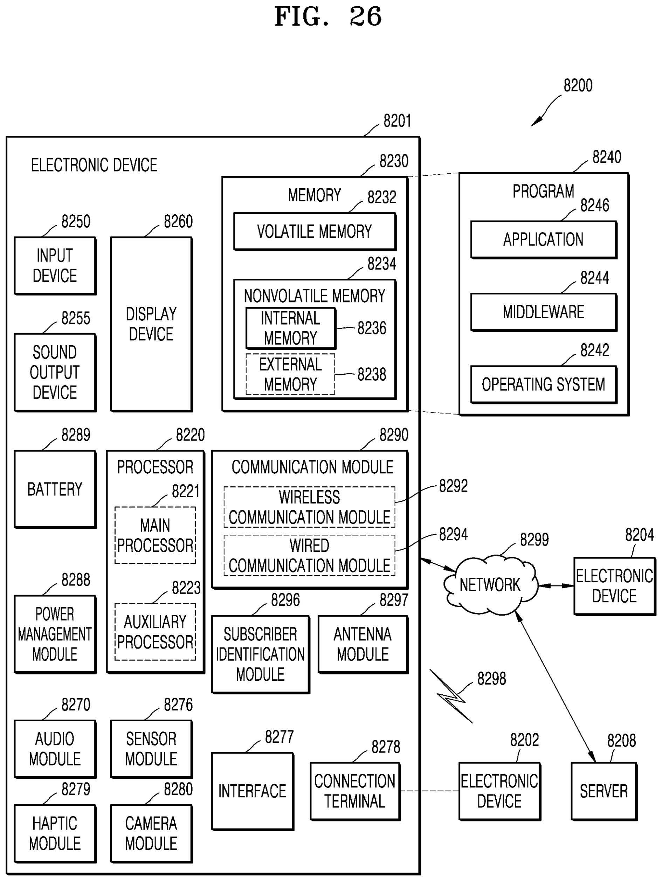

FIG. 26 is a diagram of an electronic device according to one or more embodiments.

Referring to FIG. 26, an electronic device 8201 may be provided in a network environment 8200. In the network environment 8200, the electronic device 8201 may communicate with another electronic device 8202 through the first network 8298 (a short-range wireless communication network, etc.), or with another electronic device 8204 and/or the server 8208 through the second network 8299 (a long-distance wireless communication network, etc.). The electronic device 8201 may communicate with the electronic device 8204 through the server 8208. The electronic device 8201 may include a processor 8220, a memory 8230, an input device 8250, an audio output device 8255, a display device 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. Some of these components may be omitted from the electronic device 8201 or other components may be added to the electronic device 8201. Some of these components may be implemented as one integrated circuit. For example, the sensor module 8276 (fingerprint sensor, iris sensor, illumination sensor, etc.) may be implemented by being embedded in the display device 8260 (display, etc.).

The processor 8220 may execute software (program 8240 or the like) to control one or a plurality of other components (hardware and software components, or the like) of the electronic device 8201 connected to the processor 8220, and may perform processing or operations of various data. As part of data processing or operation, the processor 8220 may load commands and/or data received from other components (sensor modules 8276, communication modules (8290, etc.), process commands and/or data stored in volatile memory 8232, and store the result data in nonvolatile memory 8234. The nonvolatile memory 8234 may include an internal memory 8236 and an external memory 8238. The processor 8220 may include a main processor 8221 (a central processing unit, an application processor, etc.) and an auxiliary processor 8223 (a graphics processing unit, an image signal processor, a sensor hub processor, a communication processor, etc.) that may be operated independently of or together with the main processor 8221. The auxiliary processor 8223 may use less power than the main processor 8221 and perform a specialized function.

The auxiliary processor 8223 may control functions and /or states related to some (the display device 8260, sensor module 8210, communication module 8290, etc.) of the components of the electronic device 8201, in place of the main processor 8221 while the main processor 8221 is in an inactive state (slip state), or together with the main processor 8221 while the main processor 8221 is in an active state (application execution state). The auxiliary processor 8223 (image signal processor, communication processor, etc.) may be implemented as part of other functionally related components (camera module 8280, communication module 8290, etc.).

The memory 8230 may store various data required by components (processor 8220 and sensor module 8276) of the electronic device 8201. The data may include, for example, input data and/or output data for software (program 8240 or the like) and related commands. The memory 8230 may include a volatile memory 8232 and/or a nonvolatile memory 8234.

The program 8240 may be stored in the memory 8230 as software, and may include an operating system 8242, middleware 8244, and/or an application 8246.

The input device 8250 may receive commands and/or data to be used in components (processor 8220, etc.) of the electronic device 8201 from the outside (user, etc.) of the electronic device 8201. The input device 8250 may include a remote controller, a microphone, a mouse, a keyboard, and/or a digital pen (such as a stylus pen, etc.).

The audio output device 8255 may output the sound signal to the outside of the electronic device 8201. The audio output device 8255 may include a speaker and/or a receiver. Speakers may be used for general purposes such as multimedia playback or recording playback, and receivers may be used to receive incoming calls. The receiver may be coupled as part of a speaker or may be implemented as an independent separate device.

The display device 8260 may visually provide information to the outside of the electronic device 8201. The display device 8260 may include a display, a hologram device, or a projector and a control circuit for controlling the corresponding devices. The display device 8260 may include a display device according to one or more embodiments. The display device 8260 may include a touch circuitry configured to sense a touch, and/or a sensor circuit (a pressure sensor, etc.) configured to measure an intensity of a force generated by the touch.

The audio module 8270 may convert sound into an electrical signal or conversely convert the electrical signal into sound. The audio module 8270 may acquire sound through the input device 8250 or output sound through the audio output device 8255 and/or a speaker and/or a headphone of another electronic device (e.g., electronic device 8202, etc.) directly or wirelessly connected to the electronic device 8201.

The sensor module 8276 may detect an operating state (power, temperature, etc.) or an external environmental state (user state, etc.) of the electronic device 8201 and generate an electrical signal and/or a data value corresponding to the sensed state. The sensor module 8276 may include a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illumination sensor.

The interface 8277 may support one or more designated protocols that may be used for electronic device 8201 to be directly or wirelessly connected to another electronic device (e.g., electronic device 8202, etc.). The interface 8277 may include a high definition multimedia interface (HDMI), a universal serial bus (USB) interface, an SD card interface, and/or an audio interface.

The connection terminal 8278 may include a connector through which the electronic device 8201 may be physically connected to another electronic device (e.g., electronic device 8202, etc.). The connection terminal 8278 may include an HDMI connector, a USB connector, an SD card connector, and/or an audio connector (such as a headphone connector, etc.).

The haptic module 8279 may convert an electrical signal to a mechanical stimulus (vibration, motion, etc.) or an electrical stimulus that a user can recognize through a tactile or motion sensation. The haptic module 8279 may include a motor, a piezoelectric element, and/or an electrical stimulus.

The camera module 8280 may capture a still image and a moving image. The camera module 8280 may include a lens assembly including one or more lenses, image sensors, image signal processors, and/or flashes. The lens assembly included in the camera module 8280 may concentrate light emitted from an object to be photographed.

The power management module 8288 may manage power supplied to the electronic device 8201. The power management module 8288 may be implemented as part of a power management integrated circuit (PMIC).

The battery 8289 may supply power to components of the electronic device 8201. The battery 8289 may include a non-rechargeable primary battery, a rechargeable secondary battery, and/or a fuel cell.

The communication module 8290 may establish a direct (wired) communication channel and/or wireless communication channel between the electronic device 8201 and another electronic device (the electronic device 8202, the electronic device 8204, the server 8208, etc.), and support communication execution through the established communication channel. The communication module 8290 may include one or more communication processors that operate independently of the processor 8220 (application processor, etc.) and support direct communication and/or wireless communication. The communication module 8290 may include a wireless communication module 8292 (a cellular communication module, a short-range wireless communication module, a Global Navigation Satellite System (GNSS), etc.) communication module, and/or a wired communication module 8294 (a local area network (LAN) communication module, a power line communication module, etc.). A corresponding communication module of these communication modules may communicate with other electronic devices through a first network 8298 (a short-range communication network such as Bluetooth, WiFi Direct, or infrared data association (IrDA)), or a second network 8299 (a long-range communication network such as a cellular network, Internet, or computer network (LAN, wide area network (WAN), etc.)). These various types of communication modules may be integrated into a single component (such as a single chip, etc.), or may be implemented as a plurality of separate components (multiple chips). The wireless communication module 8292 may identify and authenticate the electronic device 8201 in a communication network such as a first network 8298 and/or a second network 8299 using subscriber information (such as an international mobile subscriber identifier (IMSI) stored in the subscriber identification module 8296.

The antenna module 8297 may transmit a signal and/or power to the outside (such as another electronic device, etc.) or receive the signal and/or power from the outside. The antenna may include a radiator formed of a conductive pattern formed on the substrate (printed circuit board (PCB), etc.). The antenna module 8297 may include one or a plurality of antennas. When a plurality of antennas are included, an antenna suitable for a communication scheme used in a communication network such as a first network 8298 and/or a second network 8299 may be selected from among the plurality of antennas by the communication module 8290. A signal and/or power may be transmitted or received between the communication module 8290 and another electronic device through the selected antenna. Other components (radio frequency integrated circuit (RFIC), etc.) in addition to the antenna may be included as a part of the antenna module 8297.

Some of the components may be connected to each other via communication methods between peripherals (such as buses, General Purpose Input and Output (GPIO), Serial Peripheral Interface (SPI), and Mobile Industry Processor Interface (MIPI), etc.) to interchange signals (commands, data, etc.).

The command or data may be transmitted or received between the electronic device 8201 and the external electronic device 8204 through the server 8208 connected to the second network 8299. Other electronic devices 8202 and 8204 may be the same or different types of devices as the electronic device 8201. All or some of the operations executed in the electronic device 8201 may be executed in one or more of the other electronic devices 8202, 8204, and 8208. For example, when the electronic device 8201 needs to perform a function or service, it may request one or more other electronic devices to perform part or all of the function or service instead of executing the function or service on its own. One or more other electronic devices receiving the request may execute an additional function or service related to the request and transmit a result of the execution to the electronic device 8201. To this end, cloud computing, distributed computing, and/or client-server computing technology may be used.

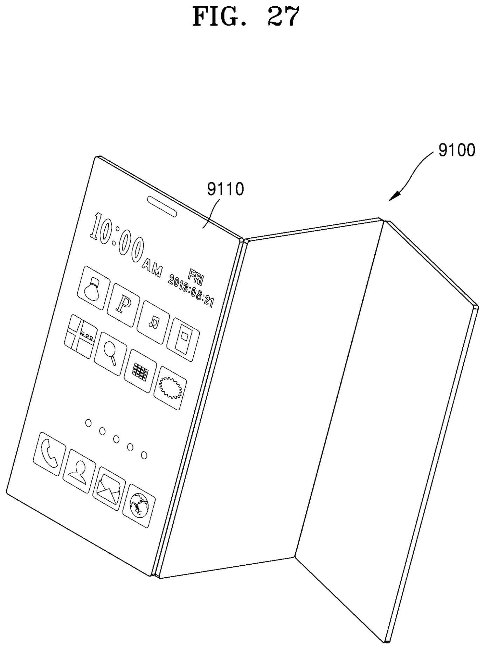

FIG. 27 is a diagram illustrating an example in which a micro light emitting display device according to one or more embodiments is applied to a mobile device. A mobile device 9100 may include a display device 9110, and the display device 9110 may include display devices according to one or more embodiments. The display device 9110 may have a foldable structure, for example, a multi-foldable structure.

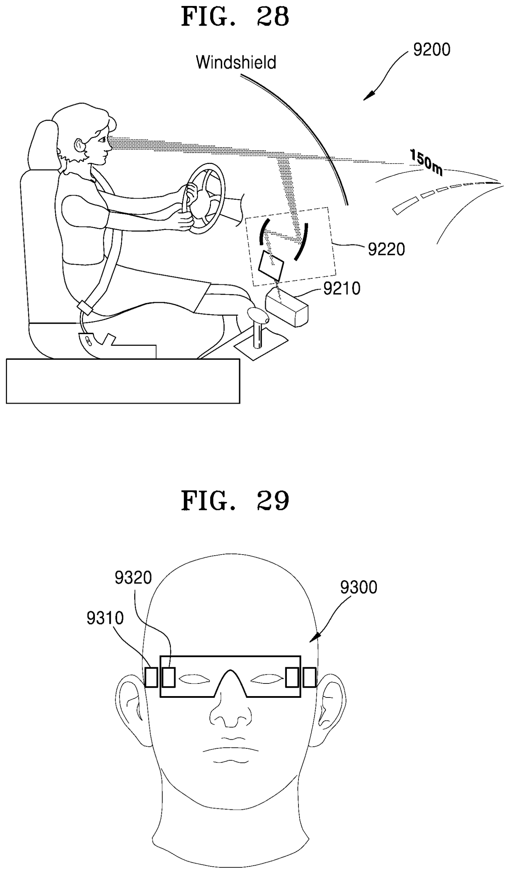

FIG. 28 is a diagram illustrating an example in which a micro light emitting display device according to one or more embodiments is applied to a vehicle display device. A display device may be a head-up display device 9200 for a vehicle, and may include a display 9210 provided in one area of the vehicle, and an optical path change member 9220 that converts an optical path so that the driver may see the image generated by the display 9210.

FIG. 29 is a diagram illustrating an example in which a micro light emitting display device according to one or more embodiments is applied to augmented reality glasses. The augmented reality glasses 9300 each may include a projection system 9310 forming an image and a waveguide 9320 guiding the image from the projection system 9310 to enter the user's eye. The projection system 9310 may include a display device according to one or more embodiments. The waveguide 9320 may be provided in, for example, a glasses frame.

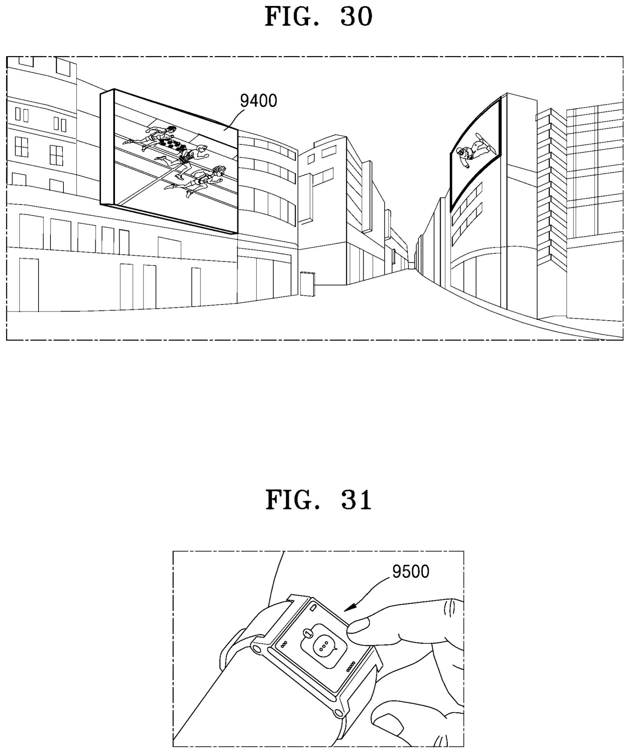

FIG. 30 is a diagram illustrating an example in which a micro light emitting display device according to one or more embodiments is applied to a signage. A signage 9400 may be used for outdoor advertisements using a digital information display and may control advertisement content, etc., through a communication network. The signage 9400 may be implemented through, for example, the electronic devices described herein.

FIG. 31 is a diagram illustrating an example in which a micro light emitting display device according to one or more embodiments is applied to a wearable display. The wearable display 9500 may include a display device according to one or more embodiments, and may be implemented through the electronic device described with reference to FIG. 26.

The display device according to one or more embodiments may be applied to various products such as a rollable television (TV) and a stretchable display.

One or more embodiments may implement a display device that displays a high-resolution color image using a micro light emitting device. The display device according to one or more embodiments may include a vertical stack structure of an epitaxial structure and an anti-reflection layer provided on the vertical stack structure to increase transmission efficiency of each color light.

In the method of manufacturing a display device according to one or more embodiments, an epitaxial structure may be formed in a vertical direction in a monolithic manner, and an anti-reflection layer may be stacked on a vertical stack structure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display device comprising:
a backplane substrate comprising at least one drive device;
at least one pixel comprising a first epitaxial structure, a second epitaxial structure, and a third epitaxial structure that are sequentially stacked on the backplane substrate;
a lens on the third epitaxial structure; and
an anti-reflection layer structure between the third epitaxial structure and the lens, wherein the anti-reflection layer structure comprises at least one anti-reflection layer,
wherein each of the first epitaxial structure, the second epitaxial structure, and the third epitaxial structure comprises a first conductivity-type semiconductor layer, an active layer, and a second conductivity-type semiconductor layer,
wherein the first epitaxial structure is configured to emit first wavelength light,
wherein the second epitaxial structure is configured to emit second wavelength light,
wherein the third epitaxial structure is configured to emit third wavelength light,
wherein the at least one anti-reflection layer of the anti-reflection layer structure has a refractive index and a thickness such that a transmittance of each of the first wavelength light, the second wavelength light, and the third wavelength light increases.

2. The display device according to claim 1, wherein the at least one anti-reflection layer comprises a single anti-reflection layer,
wherein the single anti-reflection layer has a thickness in a range of 75 nm to 110 nm, and
wherein the single anti-reflection layer comprises a material having a refractive index in a range of 1.7 to 2.

3. The display device according to claim 2, wherein a refractive index of the second conductivity-type semiconductor layer in the third epitaxial structure is n1, a refractive index of the single anti-reflection layer is n2, and a refractive index of the lens is n3, and wherein n1>n2>n3.

4. The display device according to claim 1, wherein the at least one anti-reflection layer comprises:
a first anti-reflection layer on the third epitaxial structure, and
a second anti-reflection layer between the first anti-reflection layer and the lens; and
wherein the first anti-reflection layer has a first refractive index, and the second anti-reflection layer has a second refractive index that is less than the first refractive index; and
wherein each of the first anti-reflection layer and the second anti-reflection layer has a thickness that is greater than 0 and less than or equal to 200 nm.

5. The display device according to claim 4, wherein the first refractive index is 1.9 or more, and the second refractive index is 1.9 or less; and/or
wherein a refractive index of the second conductivity-type semiconductor layer in the third epitaxial structure is n1, the first refractive index is n21, the second refractive index is n22, and a refractive index of the lens is n3, and wherein n1>n21>n22>n3.

6. The display device of any one of the previous claims, wherein the display device further comprises:
a first p-type electrode, a second p-type electrode, and a third p-type electrode between the backplane substrate and the first epitaxial structure and laterally spaced apart from each other, and
an n-type electrode between the third epitaxial structure and the anti-reflection layer structure; and/or
wherein the at least one pixel comprises a plurality of pixels, and wherein:
the at least one anti-reflection layer is shared as a single body with the plurality of pixels, or
the at least one anti-reflection layer comprises a plurality of anti-reflection layer portions, the plurality of anti-reflection layer portions respectively corresponding to the plurality of pixels.

7. The display device of any one of the previous claims, wherein the first wavelength light comprises red wavelength light, the second wavelength light comprises green wavelength light, and the third wavelength light comprises blue wavelength light; and/or
wherein the device further comprises a reflective layer between the backplane substrate and the first epitaxial structure.

8. A method of manufacturing a display device, the method comprising:
forming a third epitaxial structure on a substrate,
forming a second epitaxial structure on the third epitaxial structure,
preparing a vertical stack structure by forming a first epitaxial structure on an upper portion of the second epitaxial structure,
forming a backplane substrate,
combining the vertical stack structure with the backplane substrate such that the first epitaxial structure faces the backplane substrate,
removing the substrate,
forming an anti-reflection layer structure on the third epitaxial structure, wherein the anti-reflection layer structure comprises at least one anti-reflection layer,; and
forming a lens on the anti-reflection layer,
wherein each of the first epitaxial structure, the second epitaxial structure, and the third epitaxial structure comprises a first conductivity-type semiconductor layer, an active layer, and a second conductivity-type semiconductor layer,
wherein forming the anti-reflection layer structure comprises forming the at least one anti-reflection layer having a refractive index and a thickness such that a transmittance of each of the first wavelength light, the second wavelength light, and the third wavelength light increases.

9. The method of claim 8, wherein the at least one anti-reflection layer comprises a single anti-reflection layer,
wherein forming the anti-reflection layer structure comprises forming the single anti-reflection layer, and
wherein the single anti-reflection layer comprises a material having a refractive index in a range of 1.7 to 2.1, and
wherein the single anti-reflection layer has a thickness in a range of 75 nm to 110 nm.

10. The method according to claim 9, wherein a refractive index of the second conductivity-type semiconductor layer in the third epitaxial structure is n1, a refractive index of the anti-reflection layer is n2, and a refractive index of the lens is n3, and wherein n1>n2>n3.

11. The method of claim 8,
wherein the at least one anti-reflection layer comprises a first anti-reflection layer and a second anti-reflection layer;
wherein forming the anti-reflection layer structure comprises:
forming the first anti-reflection layer on the third epitaxial structure, and
forming the second anti-reflection layer between the first anti-reflection layer and the lens;
wherein the first anti-reflection layer has a first refractive index, and the second anti-reflection layer has a second refractive index that is less than the first refractive index, and
wherein each of the first anti-reflection layer and the second anti-reflection layer has a thickness that is greater than 0 and less than or equal to 200 nm.

12. The method of claim 11, wherein:
the first refractive index is 1.9 or more, and the second refractive index is 1.9 or less; and/or
a refractive index of the second conductivity-type semiconductor layer in the third epitaxial structure is n1, the first refractive index is n21, the second refractive index is n22, and a refractive index of the lens is n3, and
wherein n1>n21>n22>n3.

13. The method of any one of claim 8 - 12, wherein the first epitaxial structure is configured to emit red wavelength light, the second epitaxial structure is configured to emit green wavelength light, and the third epitaxial structure is configured to emit blue wavelength light.

14. The method of any one of claims 8 - 13, wherein the method further comprises:
forming a first p-type electrode, a second p-type electrode, and a third p-type electrode laterally spaced apart from each other between the backplane substrate and the first epitaxial structure, and
forming an n-type electrode between the third epitaxial structure and the anti-reflection layer structure; and/or
forming a reflective layer between the backplane substrate and the first epitaxial structure.

15. An electronic device comprising:
a display device according to any one of claims 1 - 7, and configured to form an image;
a waveguide configured to guide the image to a user's eyes.
